# EUROPEAN PATENT APPLICATION

(11) **EP 1 703 325 A1**
(43) Date of publication of application: **20.09.2006**
(21) Application number: 06110926.0
(22) Date of filing: 10.03.2006
(51) Int. Cl.: G03F 7/033, G03F 7/038, B41C 1/10, G03F 7/30

(54) **Negative working light sensitive planographic printing plate material and planographic printing plate manufacturing process**

(30) Priority: 17.03.2005 JP 2005077418
(71) Applicant: Konica Minolta Medical & Graphic, Inc., Tokyo 163-0512 (JP)
(72) Inventor: Kuroki,Takaaki Konika Minolta Med. & Graphic, Inc., Tokyo 192-8505 (JP)
(74) Representative: Gille Hrabal Struck Neidlein Prop Roos

(57) **Abstract**

Disclosed is a negative working light sensitive planographic printing plate material comprising a support and provided thereon, a light sensitive layer containing a spectral sensitizing agent, a polymerization initiator, a polymerizable compound, and a polymer as a polymeric binder, wherein the polymer has in the molecule a monomer unit with a polymerizable group and at least one of a polyvinyl ether chain, a polyvinyl pyrrolidone chain and a polyvinyl caprolactam chain.

## Description

This application is based on Japanese Patent Application No. 2005-077418, filed on March 17, 2005 in Japanese Patent Office, the entire content of which is hereby incorporated by reference.

### FIELD OF THE INVENTION

The present invention relates to a negative working light sensitive planographic printing plate material for so-called a computer-to-plate system (hereinafter referred to as CTP system), and particularly to a light sensitive planographic printing plate material suitable for so-called a processless plate capable of being developed with water and of being developed on a printing press and a process of manufacturing a planographic printing plate therefrom.

### BACKGROUND OF THE INVENTION

Presently, digital technique electronically processing, storing and outputting image information employing a computer has spread. In a plate making system of a planographic printing plate for off-set printing, a CTP system, which writes a digital image directly on a light sensitive planographic printing plate material employing a laser, has been developed and put into practical use.

It is known that of light sensitive planographic printing plate materials used for CTP, a negative working light sensitive planographic printing plate material comprising a polymerizable light sensitive layer containing a polymerizable compound is used in a printing field in which relatively high printing durability is required (see for example, Japanese Patent O.P.I. Publication Nos. 1-105238 and 2-127404.).

As a polymeric binder used in a polymerizable light sensitive layer have been used alkali-soluble organic polymers such as a methacrylic acid copolymer, acrylic acid copolymer, itaconic acid copolymer, crotonic acid copolymer, maleic acid copolymer and partially esterified maleic acid copolymer, as disclosed in Japanese Patent O.P.I. Publication No. 59-44615, Japanese Patent Publication Nos. 54-34327, 58-12577, and 54-25957, and Japanese Patent O.P.I. Publication Nos. 54-92723, 59-53836 and 59-71048.

A negative working light sensitive planographic printing plate material comprising conventional polymeric binders described above has problems in that sufficient printing durability is not obtained. When an exposure scanning speed is increased in order to increase productivity, exposure energy per unit area of the light sensitive layer surface of the planographic printing plate material is small, resulting in an insufficiently hardened light sensitive layer at exposed portions, which is susceptible to damage by alkali components in a developer.

Light sensitive compositions, comprising modified polyvinyl alcohol having in the side chain a radically polymerizable group, are disclosed in Japanese Patent O.P.I. Publication Nos. 2000-181062 and 2000-506282, however, these compositions are not those used in a planographic printing plate material. These compositions are capable of being developed with water employing water solubility of the polyvinyl alcohol. When these compositions are employed in a planographic printing plate material, it is necessary to increase a radically polymerizable group content of the modified polyvinyl alcohol in order to improve printing durability. However, the high content of the radically polymerizable group in the modified polyvinyl alcohol reduces the content of the hydroxyl group in the modified polyvinyl alcohol providing water developability, resulting in problems of lowering developability.

As a means for solving this problem, a technique is known which employs, as a polymeric binder, a modified polyvinyl alcohol having a polymerizable group and an acid group in a light sensitive layer (see for example, Japanese Patent O.P.I. Publication No. 2002-162741.). This technique somewhat improves printing durability and developability, however, it does not sufficiently meet demands of the market.

In recent years, a so-called processless printing plate material has been desired from the viewpoints of environmental protection, which does not require development employing specific chemicals. Thus, a printing process has been noticed which comprises the steps of mounting a printing plate material after image formation on a printing press without treating with any specific processing chemicals, and supplying a dampening solution and printing ink to the printing plate material to remove non-image portions and obtain a printing plate for printing (see for example, Japanese Patent O.P.I. Publication No. 4-261539.).

However, a conventional printing process employing a processless printing plate material has problems which are insufficient in ink receptivity at initial printing stage or in printing image quality, which does not meet high level of requirements of printing industries. This process has big problems particularly in a planographic printing plate employing an aluminum support.

### SUMMARY OF THE INVENTION

An object of the invention is to provide a light sensitive planographic printing plate material overcoming the above problems and giving excellent water developability, high sensitivity, high printing durability and excellent ink receptivity and to provide a manufacturing process of a planographic printing plate employing the planographic printing plate material. Another object of the invention is to provide a planographic printing plate material printing plate material adapted to a processless printing process, and to provide a manufacturing process of a planographic printing plate from the planographic printing plate material.

### DETAILED DESCRIPTION OF THE INVENTION

The above object can be attained by the following constitution.
1. A negative working light sensitive planographic printing plate material comprising a support and provided thereon, a light sensitive layer containing a spectral sensitizing agent, a polymerization initiator, a polymerizable compound, and a polymer as a polymeric binder,
   wherein the polymer has in the molecule a monomer unit with a polymerizable group and at least one of a polyvinyl ether chain, a polyvinyl pyrrolidone chain and a polyvinyl caprolactam chain.
2. The negative working light sensitive planographic printing plate material of item 1 above, wherein the polymerizable group is a radically polymerizable group.
3. The negative working light sensitive planographic printing plate material of item 1 above, wherein the polymer has an acid value of from 0 to 100.
4. The negative working light sensitive planographic printing plate material of item 1 above, wherein the polymer has in the side chain a carboxyl group.
5. The negative working light sensitive planographic printing plate material of item 4 above, wherein the polymer has an acid value of from 5 to 70.
6. The negative working light sensitive planographic printing plate material of item 1 above, wherein the polymerization initiator is at least one selected from the group consisting of a sulfonium compound, a metal arene compound, a polyhalogen compound, a boron compound, and a bisimidazole compound.
7. The negative working light sensitive planographic printing plate material of item 1 above, wherein the spectral sensitizing agent is a cyanine dye.
8. The negative working light sensitive planographic printing plate material of item 1 above, wherein the content of the monomer unit with a polymerizable group in the polymer is 5 to 50 mol%.
9. The negative working light sensitive planographic printing plate material of item 1 above, wherein the polyvinyl ether chain has a repeating unit represented by formula (1), the polyvinyl pyrrolidone chain has a repeating unit represented by formula (2), and the polyvinyl caprolactam chain has a repeating unit represented by formula (3) : 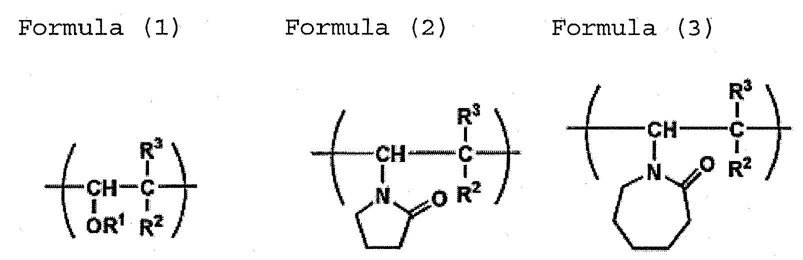 wherein R¹ represents a substituted or unsubstituted lower alkyl group, a substituted or unsubstituted cycloalkyl group, a substituted or unsubstituted aryl or heteroaryl group, or a substituted or unsubstituted aralkyl or heteroaralkyl group; R² and R³ independently represent a hydrogen atom, a substituted or unsubstituted lower alkyl group, a substituted or unsubstituted cycloalkyl group, a substituted or unsubstituted aryl or heteroaryl group, or a substituted or unsubstituted aralkyl or heteroaralkyl group.
10. The negative working light sensitive planographic printing plate material of item 1 above, wherein the polymer content of the light sensitive layer is from 10 to 90% by weight.
11. A process of manufacturing a planographic printing plate, the process comprising the steps of imagewise exposing to laser the negative working light sensitive planographic printing plate material of item 1 above, mounting the exposed planographic printing plate material on a plate cylinder of a press, and developing the exposed planographic printing plate material with a dampening solution to obtain a planographic printing plate.
12. The manufacturing method of item 11 above, wherein the laser is an infrared laser.
13. The manufacturing method of item 11 above, wherein the planographic printing plate material is heat-treated before the developing step.
14. The manufacturing method of item 11 above, wherein the planographic printing plate material is heat-treated between the exposing step and the developing step.

The present invention provides a negative working light sensitive planographic printing plate material giving excellent water developability, high sensitivity, high printing durability and excellent ink receptivity and provides a manufacturing process of a printing plate employing the planographic printing plate material. Further, the present invention provides a planographic printing plate material adapted to a processless printing process which comprises the steps of mounting the printing plate material on a plate cylinder of a printing press, imagewise exposing the printing plate material and then developing the exposed printing plate material to obtain a printing plate, and provides a manufacturing process of a printing plate employing the planographic printing plate material.

The present invention is a light sensitive planographic printing plate material comprising a support and provided thereon, a light sensitive layer containing a spectral sensitizing agent, a polymerization initiator, a polymerizable compound, and a polymer as a polymeric binder,
wherein the polymer has in the molecule a monomer unit having a polymerizable group and at least one of a polyvinyl ether chain, a polyvinyl pyrrolidone chain, and a polyvinyl caprolactam chain.

The present invention can provide a light sensitive planographic printing plate material, which provides excellent water developability, high sensitivity, high printing durability and excellent ink receptivity by employing the polymeric binder described above in the light sensitive layer, and a manufacturing process of a printing plate employing the planographic printing plate material.

The present invention will be explained below. (Polymeric binder: polymer having a polymerizable group)

The light sensitive layer of the negative working planographic printing plate material of the invention contains, as a polymeric binder, a polymer (hereinafter also referred to as the polymer in the invention) having in the molecule a monomer unit having a polymerizable group and at least one of a polyvinyl ether chain, a polyvinyl pyrrolidone chain, and a polyvinyl caprolactam chain. The polymer in the invention has function carrying other components contained in the light sensitive layer. In the invention, the polymerizable group refers to a radically polymerizable group or a cationically polymerizable group. The polymer in the invention preferably has, as the polymerizable group, a radically polymerizable group or both a radically polymerizable group and a cationically polymerizable group. Examples of the radically polymerizable group include an addition-polymerizable unsaturated group (such as (meth)acryloyl group, meth(acrylamide) group, (meth)acrylonitrile group, allyl group, a group having a styrene structure, a group having a vinyl ether structure or a group having an acetylene structure), -SH, -PH, -SiH, -GeH, and disulfide.

The addition-polymerizable unsaturated groups are preferred in view of printing durability, and among them, a (meth)acryloyl group, meth(acrylamide) group, and a group having a styrene structure is especially preferred. Herein, the (meth)acryloyl group means an acryloyl group, or a methacryloyl group.

Examples of the cationically polymerizable group include a group having a cyclic ether such as an oxirane ring, an oxetane ring, or a dioxolane ring and a group having an unsaturated ether such as vinyl ether or allyl ether.

Especially preferred is a polymer which has, as the polymerizable group, both radically polymerizable group and a cationically polymerizable group selected from an oxirane ring, an oxetane ring or a dioxolane ring.

The polymer in the invention is a polymer having in the molecule a polymerizable group and at least one of a polyvinyl ether chain, a polyvinyl pyrrolidone chain, and a polyvinyl caprolactam chain. The polyvinyl ether chain has a repeating unit represented by the following formula (1), the polyvinyl pyrrolidone chain has a repeating unit represented by the following formula (2), and the polyvinyl caprolactam chain has a repeating unit represented by the following formula (3).

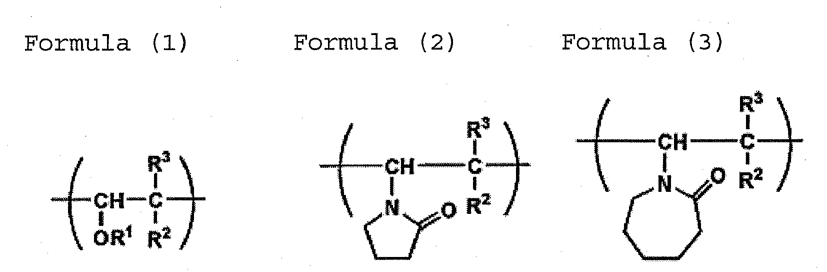

In formulae (1), (2) and (3), R¹ represents a substituted or unsubstituted lower alkyl group, a substituted or unsubstituted cycloalkyl group, a substituted or unsubstituted aryl or heteroaryl group, or a substituted or unsubstituted aralkyl or heteroaralkyl group; R² and R³ independently represent a hydrogen atom, a substituted or unsubstituted lower alkyl group, a substituted or unsubstituted cycloalkyl group, a substituted or unsubstituted aryl or heteroaryl group, or a substituted or unsubstituted aralkyl or heteroaralkyl group.

As the lower alkyl group represented by R¹, R², or R³, there is a straight-chained or branched alkyl group having a carbon atom number of from 1 to 8. Examples of the lower alkyl group include methyl, ethyl, propyl, isopropyl, butyl, sec-butyl, tert-butyl, isobutyl, pentyl, isopentyl, neopentyl, hexyl, heptyl, and octyl.

As the cycloalkyl group represented by R¹, R², or R³, there is a cycloalkyl group having a carbon atom number of from 3 to 10. Examples of the cycloalkyl group include cyclopropyl, cyclobutyl, cyclopentyl, cyclohexyl, cycloheptyl, cyclooctyl, cyclononyl, and cyclodecyl.

As the aryl group represented by R¹, R², or R³, there is an aryl group having a carbon atom number of from 6 to 14. Examples of the aryl group include phenyl, naphthyl and anthryl. As the aralkyl group represented by R¹, R², or R³, there is an aralkyl group comprised of a lower alkylene group and an aryl group having a carbon atom number of from 6 to 14, the lower alkylene group obtained by withdrawing one hydrogen from the lower alkyl group described above. Examples of the aralkyl group include benzyl, phenethyl, phenylpropyl, naphthylmethyl, naphthylethyl, and diphenylmethyl.

The heteroaryl or heteroaralkyl group represented by R¹, R², or R³ has a hetero atom such as a nitrogen atom, an oxygen atom, a sulfur atom, or a selenium atom in the aromatic ring. Examples thereof include pyridyl and quinolyl.

As the substituent of the substituted lower alkyl group or the substituted cycloalkyl group, there is, for example, the polymerizable group or lower alkoxy group described above. The number of the substituents is not specifically limited, but is preferably from 1 to 3. The lower alkyl of the lower alkoxy group as the substituent is the same as denoted above in the lower alkyl group of R¹, R² or R³.

As the substituent of the substituted aryl or heteroaryl group or the substituted aralkyl or heteroaralkyl group, there is, for example, a lower alkyl group or a lower alkoxy group. The lower alkyl of the lower alkyl group or the lower alkoxy group as the substituent is the same as denoted above in the lower alkyl group of R¹, R² or R³. The number of the substituents is not specifically limited, but is preferably from 1 to 3.

The polymer in the invention is synthesized by incorporating a polymerizable group into R¹ of a polymer (including a copolymer) having the repeating unit of formula (1). The polymer having the repeating unit of formula (1) is also synthesized by copolymerizing a co-monomer having a polymerizable group with vinyl ether, whereby the polymerizable group is incorporated in the polymer. The latter method is preferred.

A polymer having a polyvinyl ether chain and a synthetic method thereof as disclosed in Japanese Patent O.P.I. Publication Nos. 2004-330628 and 2004-307462 are also applied to the invention.

In the polymer in the invention having the polyvinyl pyrrolidone chain of formula (2) or the polyvinyl caprolactam chain of formula (3) and polymerizable group, the polymerizable group is incorporated through a comonomer unit contained in the polymer.

Incorporation of the polymerizable group into a polymer is carried out by reacting a copolymer having a unit with a conventional reactive group such as a hydroxyl group, a carboxyl group, an amino group, an epoxy group or an aldehyde group with a polymerizable group-containing monomer. For example, a method described later can be used which reacts a carboxyl group with a glycidyl group, or reacts a hydroxyl group with an isocyanate group.

Typically, incorporation of a polymerizable group in a polymer is carried out by reacting a copolymer having a carboxyl group-containing monomer unit with an aliphatic epoxy-containing unsaturated compound such as allyl glycidyl ether, glycidyl (meth)acrylate, α-ethylglycidyl (meth)acrylate, glycidyl crotonate, glycidyl isocrotonate, crotonyl glycidyl ether, itaconic acid monoalkylmonoglycidyl ester, fumaric acid monoalkylmonoglycidyl ester or maleic acid monoalkylmonoglycidyl ester; or an alicyclic epoxy-containing unsaturated compound such as 3,4-epoxycyclohexylmethyl (meth)acrylate.

In the invention, when an amount of the carboxyl group reacted with the epoxy-containing unsaturated compound is represented in terms of mol%, the amount is preferably from 5 to 50 mol%, and more preferably from 10 to 30 mol% in view of sensitivity and printing durability.

Reaction of a copolymer having a carboxyl group-containing monomer unit with an epoxy-containing unsaturated compound is carried out for example, at 80 to 120 °C for 1 to 50 hours. The reaction product can be synthesized according to a conventional polymerization method, for example, a method described in literatures such as W.R. Sorenson & T.W. Cambell "Kobunshi Gosei Jikkenho" published by TOKYO KAGAKU DOHJIN, or Japanese Patent O.P.I. Publication Nos. 10-315598 and 11-271963, or a method similar to the above.

As reactions for the polymerizable group incorporation, there are acetalization due to reaction of a hydroxyl group and an aldehyde group, ring-opening reaction of an epoxy group, and esterification employing a carboxylic acid, an acid chloride or an acid anhydride. As compounds having a radically reactive group and a functional group capable of reacting with a hydroxyl group, there are aldehydes, glycidyl (meth)acrylate, (meth)acryloyl isocyanate, (meth)acryloyloxyethyl isocyanate, (meth)acrylic acid, (meth)acrylic acid anhydride, and (meth)acrylic acid chloride, each disclosed in Japanese Patent O.P.I. Publication Nos. 2002-181062 and 2000-506282, and the compounds described below.

Examples of the carboxyl group-containing monomer include an *α*, β-unsaturated carboxylic acid, for example, acrylic acid, methacrylic acid, maleic acid, maleic anhydride, itaconic acid, itaconic anhydride or a carboxylic acid such as a half ester of phthalic acid with 2-hydroxymethacrylic acid.

The polymeric binder in the invention can further contain, as another co-monomer unit, a monomer unit derived from the monomer described in the following items (1) through (15) :
1) A monomer having an aromatic hydroxy group, for example, o-, (p- or m-) hydroxystyrene, or o-, (p- or m-) hydroxyphenylacrylate;
2) A monomer having an aliphatic hydroxy group, for example, 2-hydroxyethyl acrylate, 2-hydroxyethyl methacrylate, N-methylolacrylamide, N-methylolmethacrylamide, 4-hydroxybutyl acrylate, 4-hydroxybutyl methacrylate, 5-hydroxypentyl acrylate, 5-hydroxypentyl methacrylate, 6-hydroxyhexyl acrylate, 6-hydroxyhexyl methacrylate, N-(2-hydroxyethyl)acrylamide, N-(2-hydroxyethyl)methacrylamide, or hydroxyethyl vinyl ether;
3) A monomer having an aminosulfonyl group, for example, m- or p-aminosulfonylphenyl methacrylate, m- or p-aminosulfonylphenyl acrylate, N-(p-aminosulfonylphenyl) methacrylamide, or N-(p-aminosulfonylphenyl)acrylamide;
4) A monomer having a sulfonamido group, for example, N-(p-toluenesulfonyl)acrylamide, or N-(p-toluenesulfonyl)-methacrylamide;
5) An acrylamide or methacrylamide, for example, acrylamide, methacrylamide, N-ethylacrylamide, N-hexylacrylamide, N-cyclohexylacrylamide, N-phenylacrylamide, N-nitrophenylacrylamide, N-ethyl-N-phenylacrylamide, N-4-hydroxyphenylacrylamide, or N-4-hydroxyphenylmethacrylamide;
6) A monomer having a fluorinated alkyl group, for example, trifluoromethyl acrylate, trifluoromethyl methacrylate, tetrafluoropropyl methacrylate, hexafluoropropyl methacrylate, octafluoropentyl acrylate, octafluoropentyl methacrylate, heptadecafluorodecyl methacrylate, heptadecafluorodecyl methacrylate, or N-butyl-N-(2-acryloxyethyl)heptadecafluorooctylsulfonamide;
7) A vinyl ether, for example, ethyl vinyl ether, 2-chloroethyl vinyl ether, propyl vinyl ether, butyl vinyl ether, octyl vinyl ether, or phenyl vinyl ether;
8) A vinyl ester, for example, vinyl acetate, vinyl chroloacetate, vinyl butyrate, or vinyl benzoate;
9) A styrene, for example, styrene, methylstyrene, or chloromethystyrene;
10) A vinyl ketone, for example, methyl vinyl ketone, ethyl vinyl ketone, propyl vinyl ketone, or phenyl vinyl ketone;
11) An olefin, for example, ethylene, propylene, isobutylene, butadiene, or isoprene;
12) N-vinylpyrrolidone, N-vinylcarbazole, or N-vinylpyridine,
13) A monomer having a cyano group, for example, acrylonitrile, methacrylonitrile, 2-pentenenitrile, 2-methyl-3-butene nitrile, 2-cyanoethyl acrylate, or o-, m- or p-cyanostyrene;
14) A monomer having an amino group, for example, N,N-diethylaminoethyl methacrylate, N,N-dimethylaminoethyl acrylate, N,N-dimethylaminoethyl methacrylate, polybutadiene urethane acrylate, N,N-dimethylaminopropyl acrylamide, N,N-dimethylacrylamide, acryloylmorpholine, N-isopropylacrylamide, or N,N-diethylacrylamide.
15) Alkyl methacrylate or alkyl acrylate etc., i.e., an unsubstituted alkyl ester such as methyl methacrylate, ethyl methacrylate, propyl methacrylate, butyl methacrylate, amyl methacrylate, hexyl methacrylate, heptyl methacrylate, octyl methacrylate, nonyl methacrylate, decyl methacrylate, undecyl methacrylate, dodecyl methacrylate, methyl acrylate, ethyl acrylate, propyl acrylate, butyl acrylate, amyl acrylate, hexyl acrylate, heptyl acrylate, octyl acrylate, nonyl acrylate, decyl acrylate, undecyl acrylate or dodecyl acrylate; a cyclic alkyl ester such as cyclohexyl methacrylate or cyclohexyl acrylate; and a substituted alkyl ester such as benzyl methacrylate, 2-chloroethyl methacrylate, N,N-dimethylaminoethyl methacrylate, glycidyl methacrylate, benzyl acrylate, 2-chloroethyl acrylate, N,N-dimethylaminoethyl acrylate or glycidyl acrylate.

Further another monomer may be copolymerized with the above monomer.

An unsaturated bond-containing copolymer is also preferred which is obtained by reacting a carboxyl group contained in the above vinyl copolymer molecule with for example, a compound having a (meth)acryloyl group and an epoxy group.

Examples of the compound having an unsaturated bond and an epoxy group in the molecule include glycidyl acrylate, glycidyl methacrylate and an epoxy group-containing unsaturated compound disclosed in Japanese Patent O.P.I. Publication No. 11-27196.

Among those described above, the polymeric binder in the invention is preferably a polymer having a polymerizable unsaturated group, and the content of the unit having a polymerizable unsaturated group in the polymer is preferably from 5 to 50 mol% based on the total repeating units of the polymer.

The polymer in the invention has a polyvinyl pyrrolidone chain, a polyvinyl caprolactam chain or a polyvinyl ether chain, and the content of the repeating unit from vinyl pyrrolidone, the repeating unit from vinyl caprolactam or the repeating unit from vinyl ether in the polymer is preferably not less than 20 mol%, more preferably not less than 40 mol%, and still more preferably not less than 60 mol%, based on the total repeating units of the polymer.

In the invention, the polyvinyl pyrrolidone chain and polyvinyl caprolactam are preferred.

The polymer in the invention comprising a polymerizable group may be in the form of block copolymer or random copolymer.

The polymer in the invention has an acid value of preferably from 0 to 100, more preferably from 5 to 70, and still more preferably from 10 to 40.

In the invention, the acid value refers to the number of mg of potassium hydroxide (KOH) necessary to neutralize 1 g of the polymer described above. The acid value can be determined as follows: A sample is diluted with methylcellosolve by a factor of 50, and the resulting solution is titrated with a 0.1 mol/liter potassium hydroxide solution. Inflection point of the pH curve obtained according to a pH meter is a neutralizing point, and the acid value is obtained from an amount of potassium hydroxide necessary to reach the neutralizing point.

The weight average molecular weight of the polymer in the invention is preferably from 5,000 to 500,000 and more preferably 10,000 to 300,000, measured by gel permeation chromatography (GPC).

The degree of dispersion of the molecular weight of the polymer in the invention is preferably from 1.5 to 7, and more preferably from 1.8 to 5.

The glass transition point (Tg) of the polymer in the invention is preferably from 40 to 200 °C, more preferably from 50 to 175 °C, and still more preferably from 60 to 150 °C. Herein, the glass transition point (Tg) means temperature corresponding to an intersection point of two straight lines when the specific volume of polymer is measured as a function of temperature, which is determined according to differential scanning calorimetry (DSC). Tg of the polymeric binder in the invention is a value determined according to DSC.

The polymerer in the invention is preferably water-soluble. The polymeric binder in the invention is one which is dissolved in 25 °C water in an amount of preferably not less than 1% by weight, more preferably not less than 3% by weight, and still more preferably not less than 5% by weight.

The water solubility as described above of the polymer in the invention is important in developing a printing plate material on a press (on-press development). The present inventor has found that the planographic printing plate material of the invention satisfies high mechanical strength and ink receptivity (lipophilic property) inconsistent with water solubility above, which are required, and completed the invention.

The content of the polymer in the light sensitive layer is preferably from 10 to 90% by weight, more preferably from 20 to 85% by weight, and still more preferably from 30 to 80% by weight, in view of sensitivity.

### (Polymerization initiator)

The polymerization initiator is a compound capable of initiating polymerization of a polymerizable compound upon imagewise exposure. In the invention, various conventional polymerization initiators can be used. As the polymerization initiators, there are, for example, aromatic ketones, aromatic onium salts, organic peroxides, thio compounds, hexarylbiimidazoles, ketoxime esters, borate compounds, azinium compounds, metallocenes, active ester compounds, and compounds having a carbon-halogen bond. Further, compounds used in a chemical amplification type photo resist or in photopolymerization are also used (Organic electronics material seminar "Organic material for imaging" from Bunshin publishing house (1993), refer to page 187-192).

Examples of the polymerization initiator include radical generating compounds disclosed in Japanese Patent Publication No. 2002-537419, polymerization initiators disclosed in Japanese Patent O.P.I. Publication Nos. 2001-175006, 2002-278057, and 2003-5363, onium salts having two or more cation portions in the molecule disclosed in Japanese Patent O.P.I. Publication No. 2003-76010, N-nitroso amine compounds disclosed in Japanese Patent O.P.I. Publication No. 2001-133966, thermally radical generating compounds disclosed in Japanese Patent O.P.I. Publication No. 2001-343742, compounds of generating a radical or an acid by heat disclosed in Japanese Patent O.P.I. Publication No. 2002-6482, borate compounds disclosed in Japanese Patent O.P.I. Publication No. 2002-116539, compounds of generating a radical or an acid by heat disclosed in Japanese Patent O.P.I. Publication No. 2002-148790, photopolymerization initiators or thermal polymerization initiators each having a polymerizable unsaturated group disclosed in Japanese Patent O.P.I. Publication No. 2002-207293, onium salts having, as a counter ion, a divalent or more valent anion disclosed in Japanese Patent O.P.I. Publication No. 2002-268217, sulfonylsulfone compounds having a specific structure disclosed in Japanese Patent O.P.I. Publication No. 2002-328465, thermally radical generating compounds disclosed in Japanese Patent O.P.I. Publication No. 2002-341519, iron-arene complexes disclosed in Japanese Patent O.P.I. Publication No. 59-219307, and hexaarylbisimidazoles disclosed in Japanese Patent O.P.I. Publication No. 2003-295426.

Preferred polymerization initiators are sulfonium compounds, metal-arene compounds, polyhalogen compounds, boron compounds, and bisimidazole compounds.

Next, preferred polymerization initiators will be explained.

### (Sulfonium compound)

As the polymerization initiator in the invention, a sulfonium compound, particularly a sulfonium salt is preferably used. Among the sulfonium salts, a triarylsulfonium salt is especially preferred, since it provides good storage stability, increases easily its addition amount in a light sensitive composition due to its good solubility in a polymerizable compound, and decreases unreacted polymerizable compound after polymerization.

As the triarylsulfonium salt, a triarylsulfonium salt is preferred in view of solubility, sensitivity or storage stability, which is represented by the following formula (S1), (S2), (S3) or (S4) :

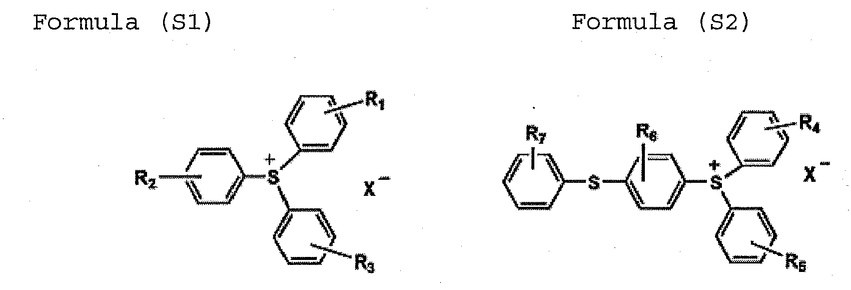

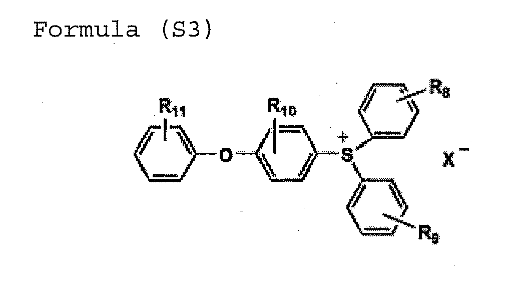

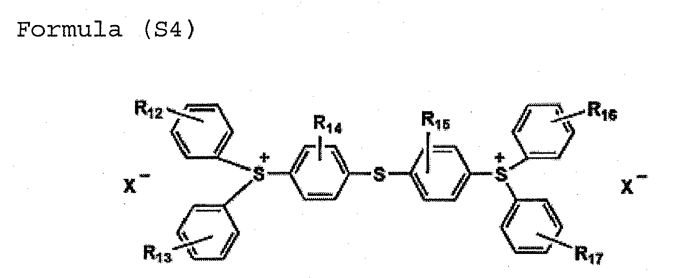

In formulae (S1) through (S4) above, R₁ through R₁₇ independently represent a hydrogen atom or a substituent, provided that R₁ through R₁₃ are not simultaneously hydrogens, R₄ through R₇ are not simultaneously hydrogens, R₈ through R₁₁ are not simultaneously hydrogens, and R₁₂ through R₁₇ are not simultaneously hydrogens; and X⁻ represents an anioic group.

The substituent represented by R₁ through R₁₇ is preferably an alkyl group such as a methyl group, an ethyl group, a propyl group, an isopropyl group, a butyl group, an isobutyl group, a t-butyl group, a pentyl group or a hexyl group; an alkoxy group such as a methoxy group, an ethoxy group, a propoxy group, a butoxy group, a hexyloxy group, a decyloxy group, or a dodecyloxy group; a carbonyl group such as an acetoxy group, propionyloxy group, a decylcarbonyloxy group, a dodecylcarbonyloxy group, a methoxycarbonyl group, an ethoxycarbonyl group or a benzoyloxy group; a phenylthio group; a halogen atom such as fluorine, chlorine, bromine or iodine; a cyano group, a nitro group or a hydroxy group.

Examples of the anionic group represented by X⁻ include a halogen ion such as F⁻, Cl⁻, Br⁻ or I⁻; and an anion such as B(C₆F₅)₄⁻, R₁₈COO⁻, R₁₉SO₃⁻, SbF₆⁻, AsF₆⁻, PF₆⁻ or BF₄⁻, in which R₁₈ and R₁₉ independently represent an alkyl group such as a methyl group, an ethyl group, a propyl group or a butyl group; an alkyl group having, as a substituent, a halogen atom such as fluorine, chlorine, bromine or iodine, a nitro group, a cyano group, or an alkoxy group such as a methoxy group or an ethoxy group; or a phenyl group. Among these, B(C₆F₅)₄⁻ or PF₆⁻ is preferred in view of safety.

These compounds can be easily synthesized according to a conventional synthetic method, for example, in the same manner as the synthetic method of photolytically acid generating agent disclosed in "THE CHEMICAL SOCIETY OF JAPAN", Nol. 71, No. 11 (1998) or in "Organic material for imaging" edited by Yukierekutoronikusuzairyo Kenkyukaiand published by Bunshin publishing house (1993).

The sulfonium salt represented by formula (S1) through (S4) above is preferably a sulfonium salt selected from the sulfonium salts represented by the following formulae (S5) through (S13): 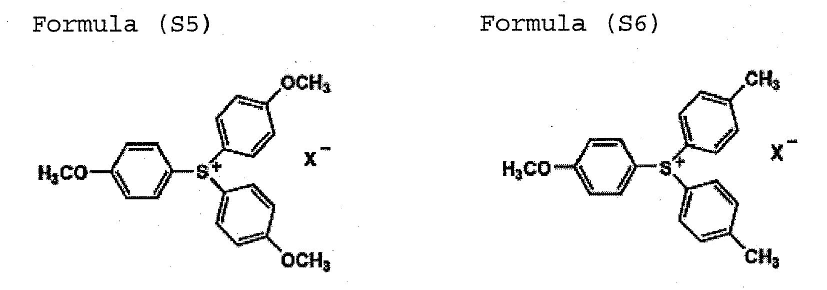 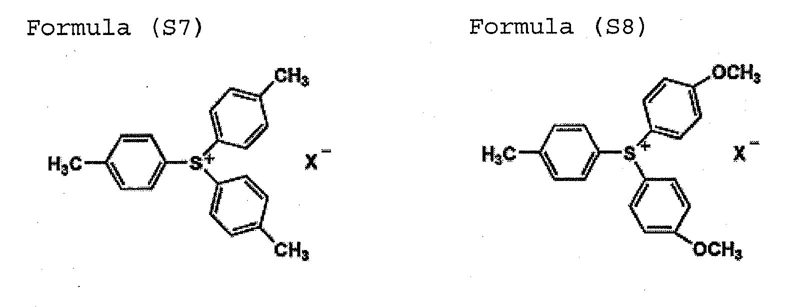 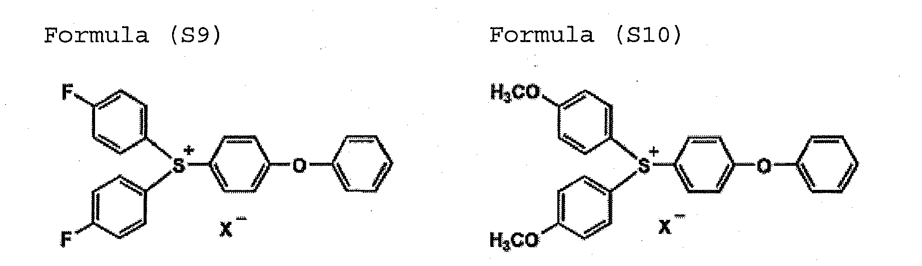 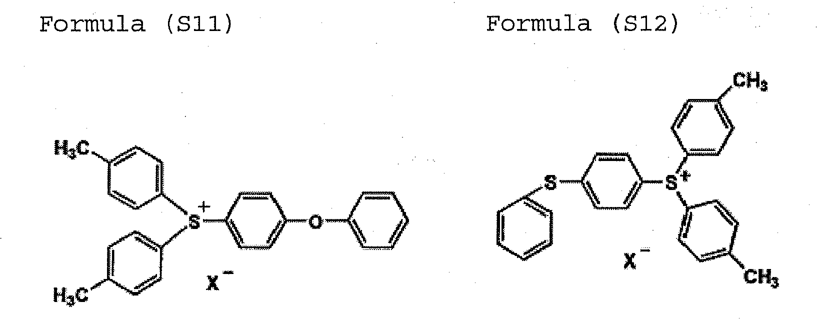 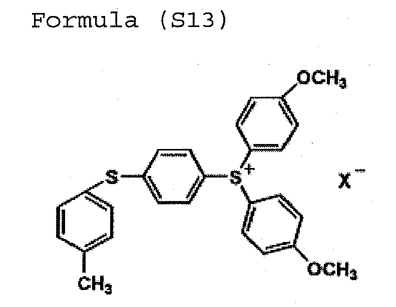 wherein X⁻ represents an anion and is the same as denoted above in X⁻ of formulae (S1) through (S4) above.

Examples of a sulfonium salt represented by formula (S1), (S2), (S3) or (S4) include sulfonium salts represented by formulae (S5) through (S13) wherein X⁻ is PF₆⁻ and the following compounds:

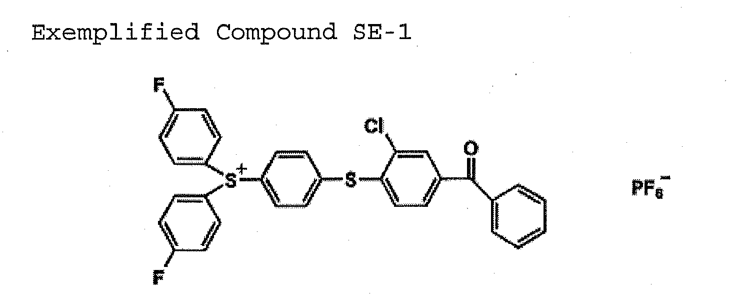

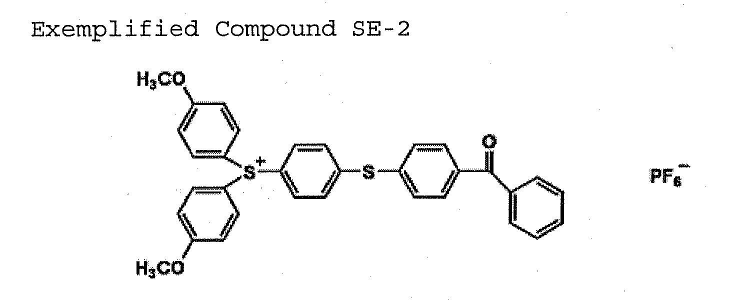

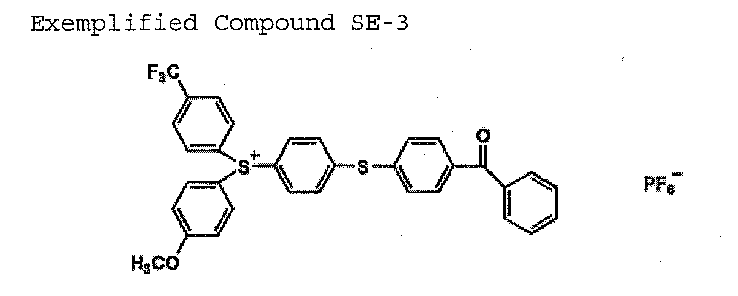

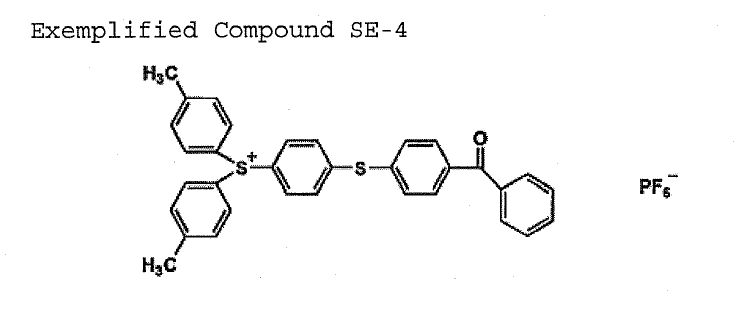

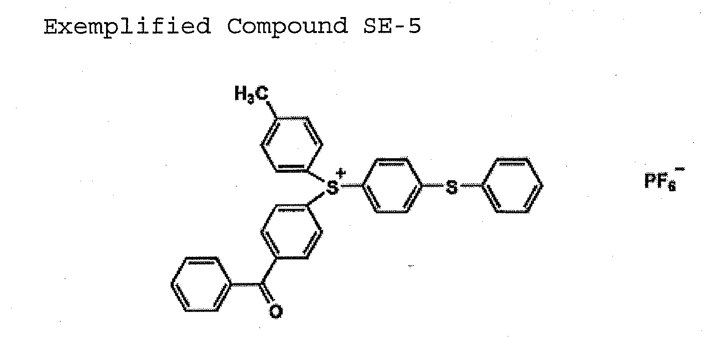

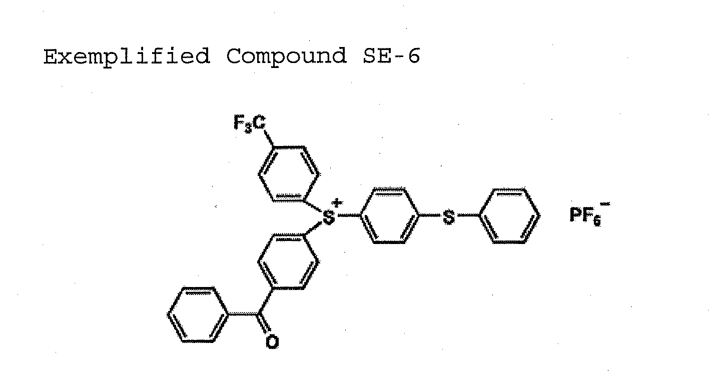

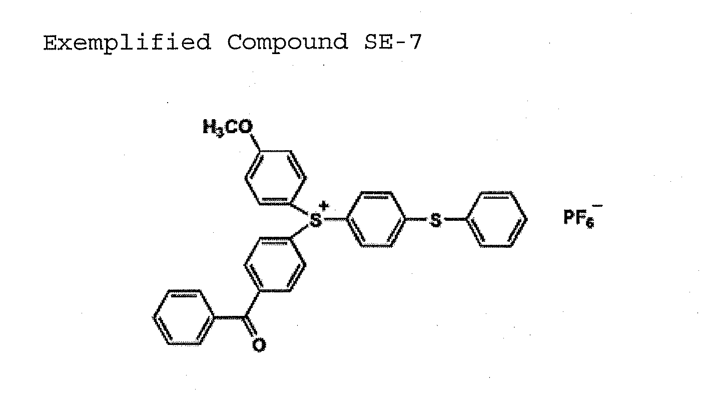

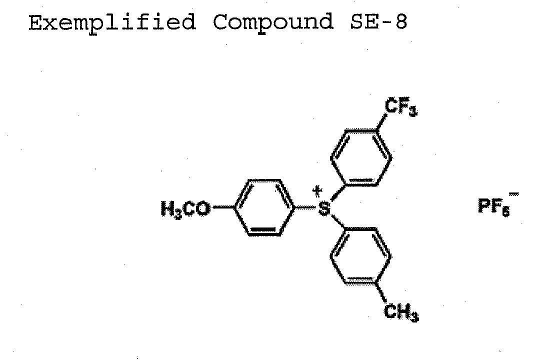

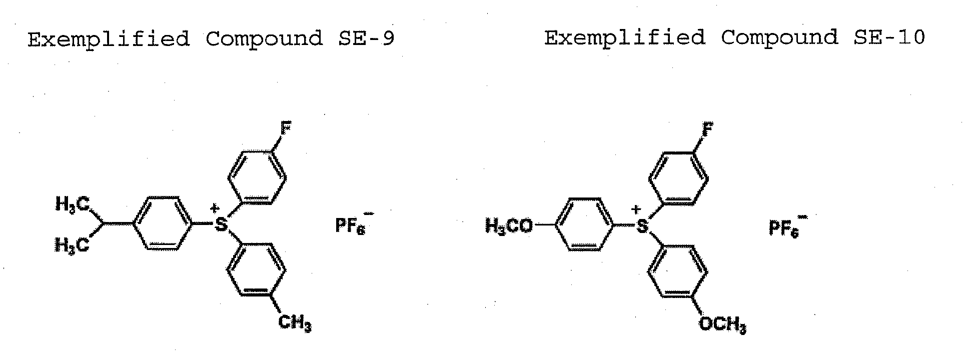

### (Metal-arene compound)

The metal-arene compound, which is preferably used as a polymerization initiator in the invention, is a compound represented by the following formula (MA), 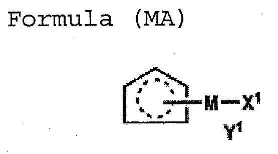 wherein X¹ represents a group comprising at least one benzene ring; Y¹ represents BF₄⁻, PF₆⁻, AsF₆⁻ or SbF₆⁻; and M represents a metal such as iron, nickel of cobalt.

Among the metal arene compounds, an iron-arene compound, a chromium-arene compound, a manganese-arene compound, a cobalt-arene compound, and a nickel-arene compound are preferred, and an iron-arene compound is especially preferred in obtaining high sensitivity.

As the iron arene compounds, there are those described in Japanese Patent O.P.I. Publication No. 59-219307. Preferred examples of the iron arene compounds include η-benzene-(η-cyclopentadienyl)iron·hexafluorophosphate, η-cumene)-(η-cyclopentadienyl)iron·hexafluorophosphate, η-fluorene-(η-cyclopentadienyl)iron·hexafluorophosphate, η-naphthalene-(η-cyclopentadienyl)iron·hexafluorophosphate, η-xylene-(η-cyclopentadienyl)iron·hexafluorophosphate, and η-benzene-(η-cyclopentadienyl)iron·tetrafluoroborate.

### (Polyhalogen compound)

In the invention, a polyhalogen compound can be used in combination as the polymerization initiator. As the polyhalogen compound, a compound represented by formula (PH1), (PH2) or (PH3) is preferred. 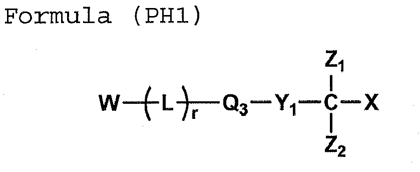 wherein Z₁ and Z₂ independently are a halogen atom; X is a hydrogen atom or an electron-withdrawing group; Y₁ is -CO- or -SO₂-; Q₃ is an arylene group or a divalent heterocyclic group; L is a linkage group; W is a carboxyl group or its salt, a sulfo group or its salt, a phosphoric acid group or its salt, a hydroxyl group, a quaternary ammonium group or a polyethyleneoxy group; and r is 0 or 1. 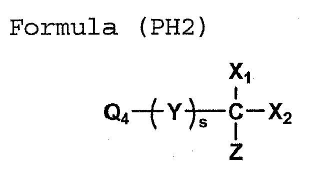 wherein Q₄ is an alkyl group, an aryl group or a heterocyclic group; X₁ and X₂ are each a halogen atom; Z is a hydrogen atom or an electron-withdrawing group; Y is -C(=O)-, -SO- or -SO₂-; and s is 0 or 1. 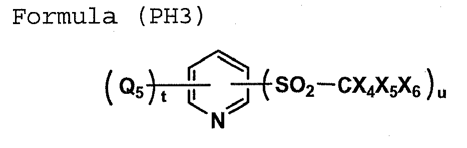 wherein Q₅ is an alkyl group, an aryl group or a heterocyclic group; X₄, X₅ and X₆ are each a hydrogen atom or a halogen atom, provided that at least one of X₄, X₅ and X₆ is a halogen atom; t is an integer of 0 to 4; and u is an integer of 1 to 5.

Typical examples of the compounds represented by formula (PH1), (PH2) or (PH3) will be listed below, but the invention is not limited thereto.

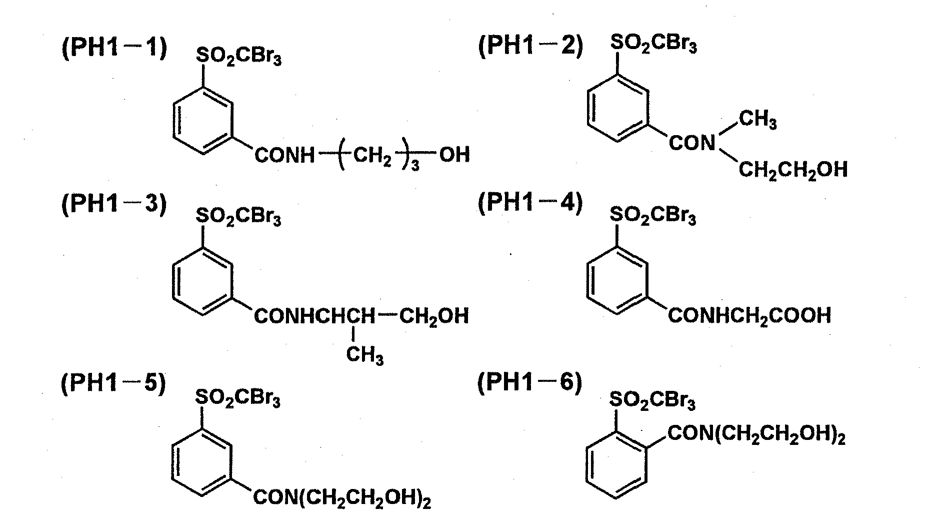

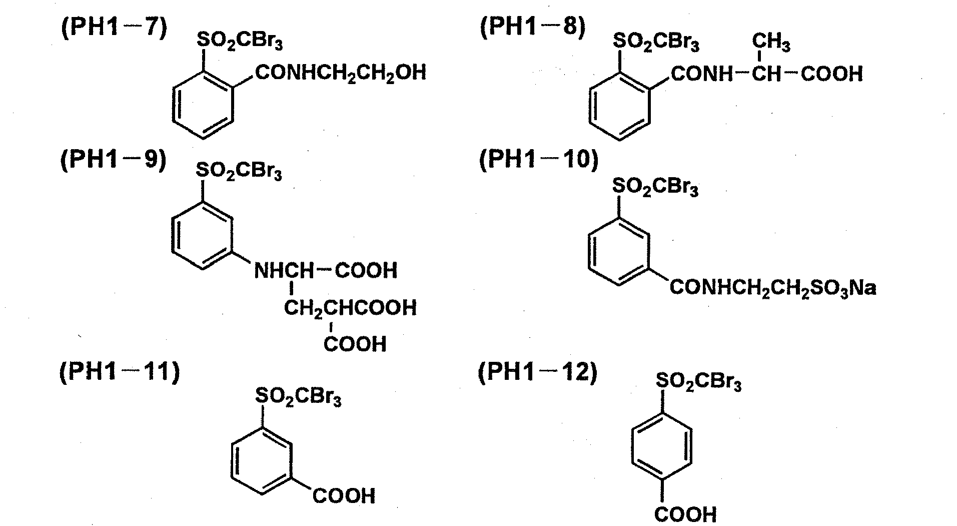

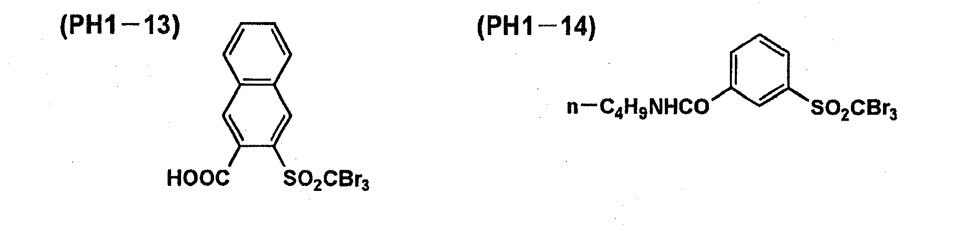

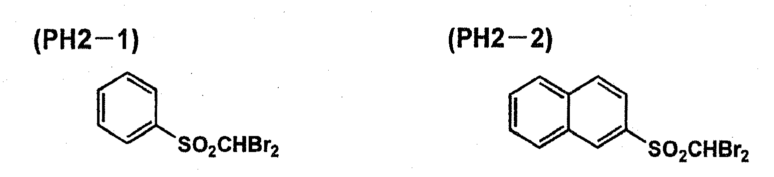

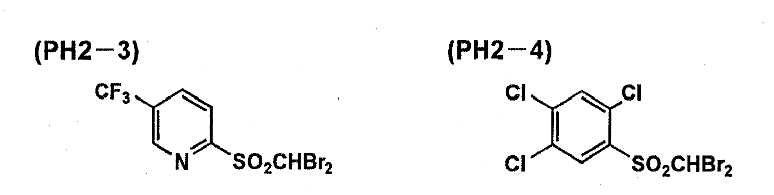

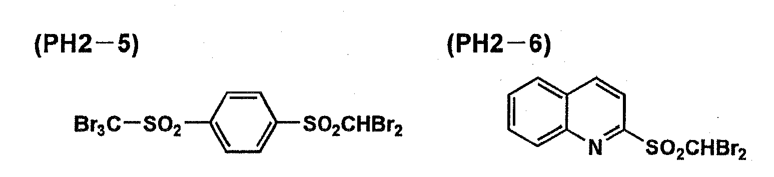

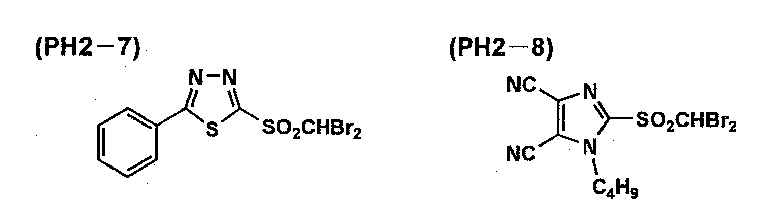

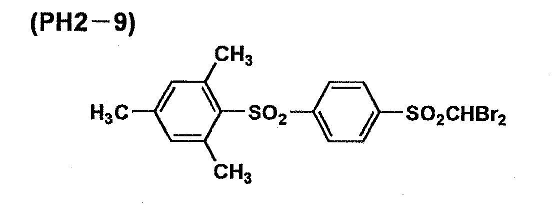

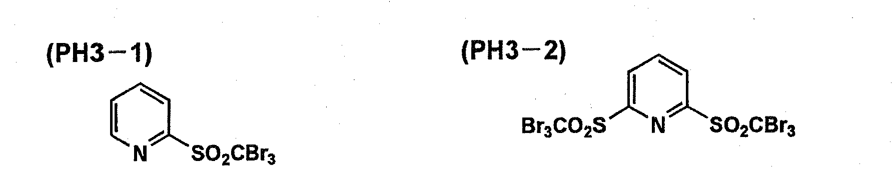

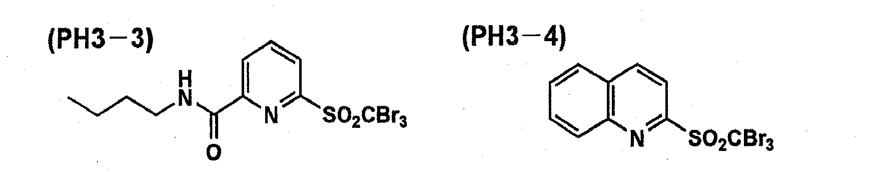

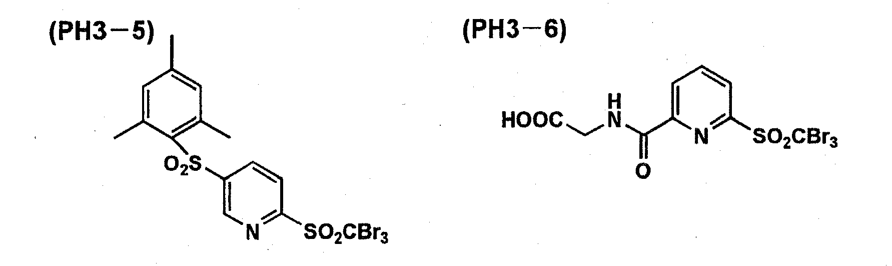

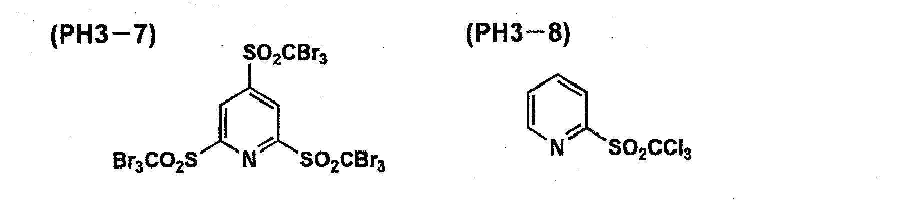

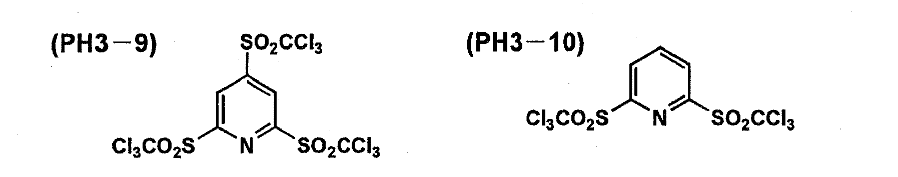

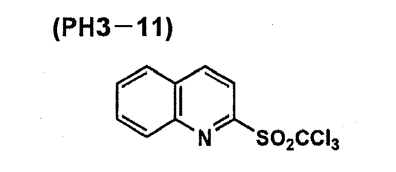

The polyhalogen compound in the invention is preferably a polyhaloacetyl compound, and more preferably a trihaloacetylamide compound. The polyhaloacetyl compound is preferably a compound represented by the following formula (PH4), and more preferably a compound represented by the following formula (PH5).

Formula (PH4) R¹¹-C(X¹⁰)₂- (C=O)-R¹²

wherein X¹⁰ represents a chlorine atom or a bromine atom; R¹¹ represents a hydrogen atom, a chlorine atom, a bromine atom, an alkyl group, an aryl group, an acyl group, an alkylsulfonyl group, an arylsulfonyl group or a cyano group; R¹² represents a monovalent substituent, provided that R¹¹ and R¹² may combine with each other to form a ring.

Formula (PH5) C (X¹¹)₃- (C=O)-Y¹⁰-R¹³

wherein X¹¹ represents a chlorine atom or a bromine atom; R¹³ represents a monovalent substituent; and Y¹⁰ represents -O-, or -NR¹⁴ in which R¹⁴ represents a hydrogen atom or an alkyl group, provided that R¹³ and R¹⁴ may combine with each other to form a ring.

Typical exemplified compounds (BR 1 through BR 76) of compounds represented by formula (PH4) are listed below, but the invention is not limited thereto.

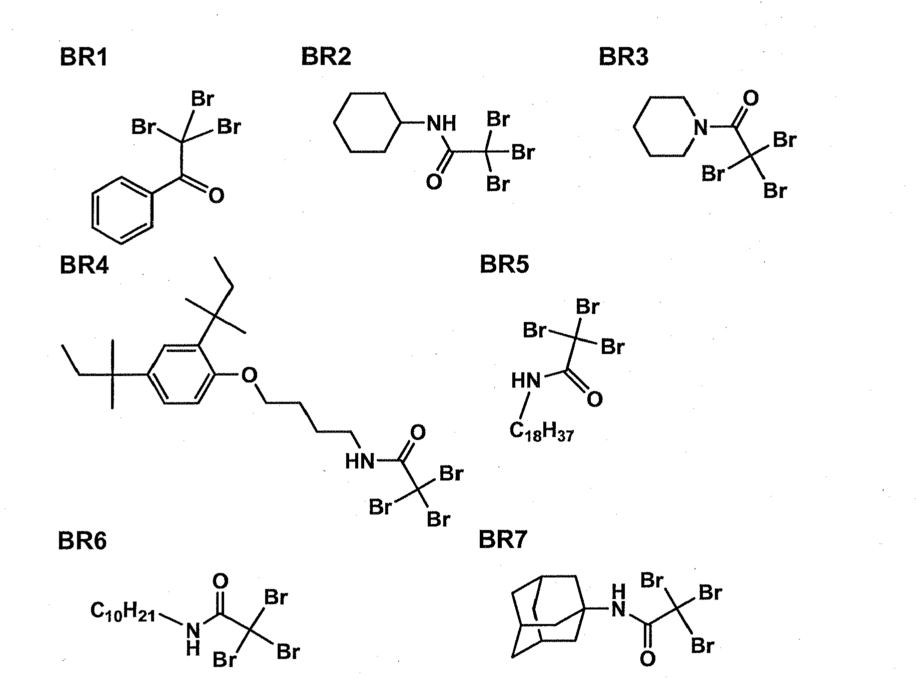

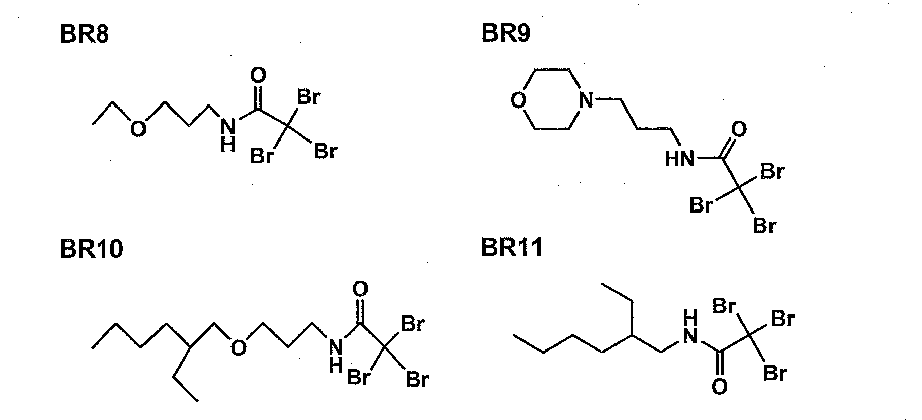

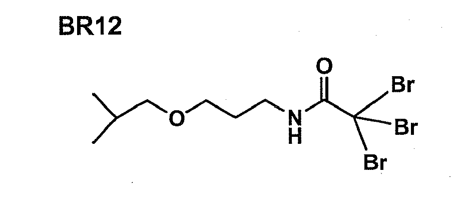

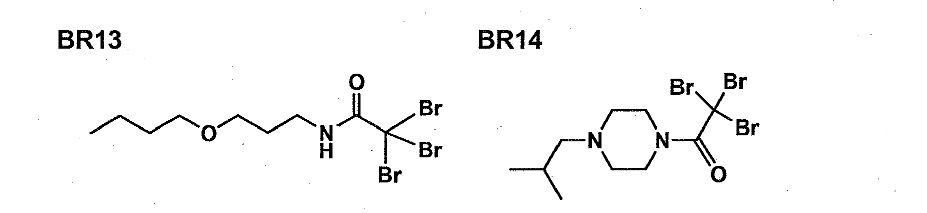

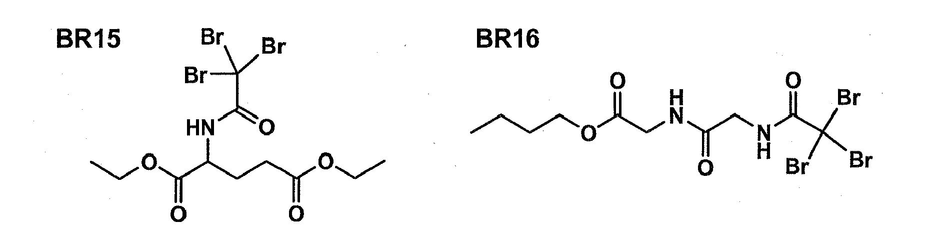

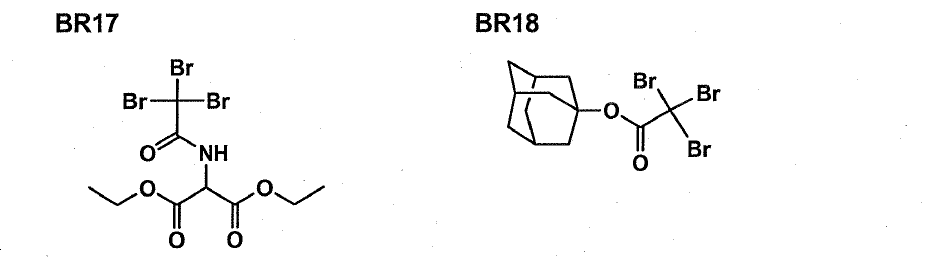

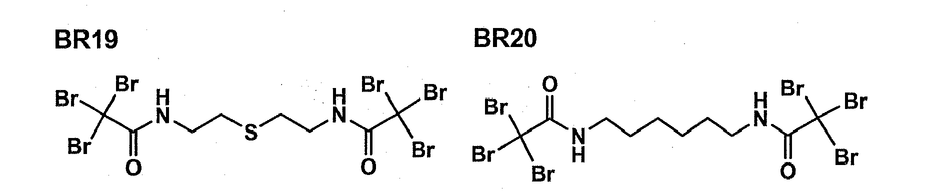

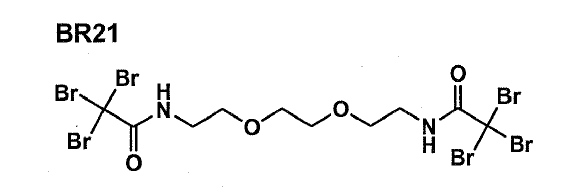

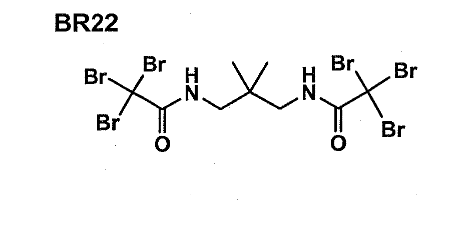

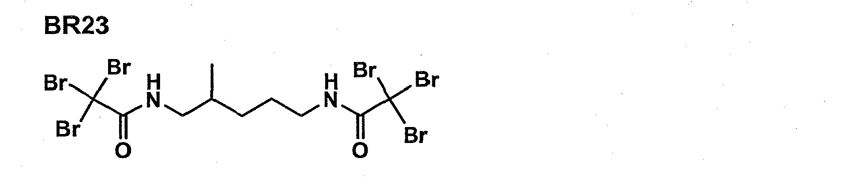

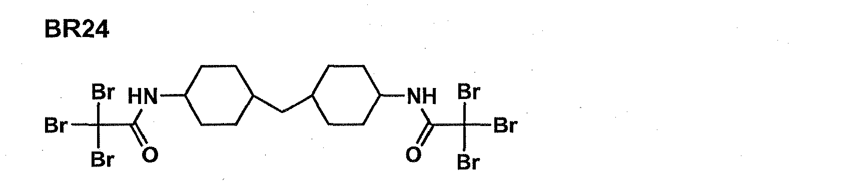

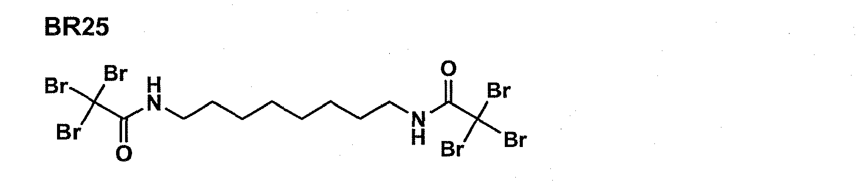

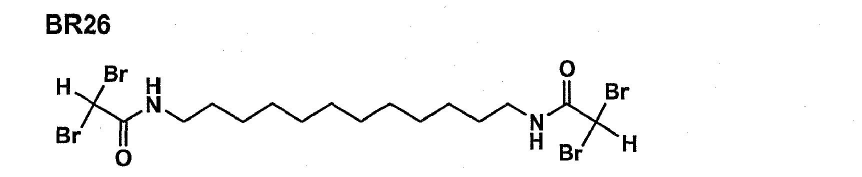

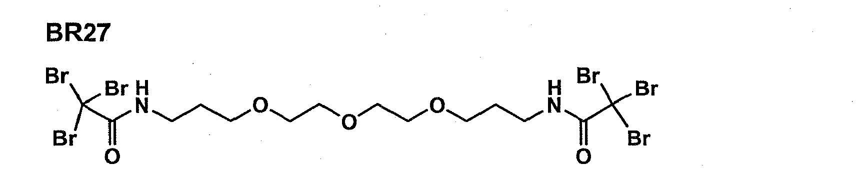

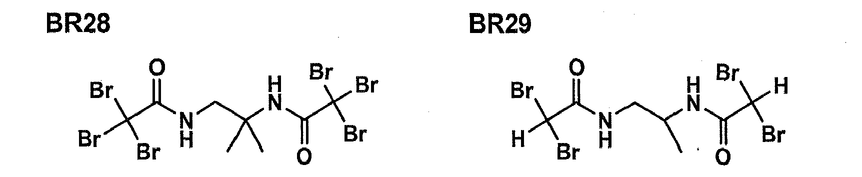

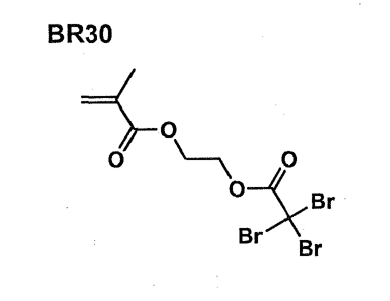

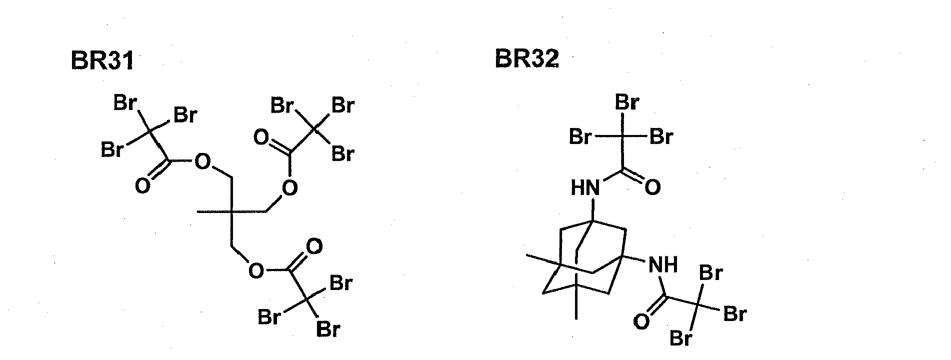

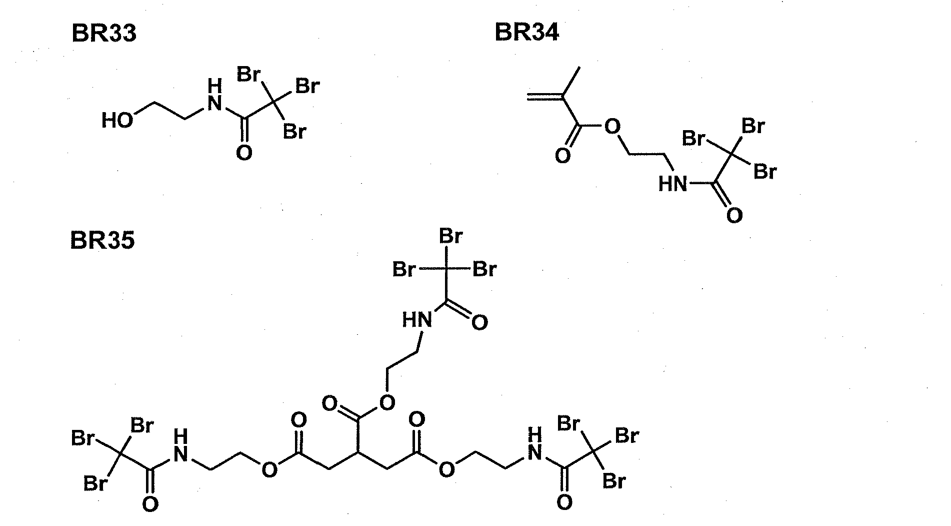

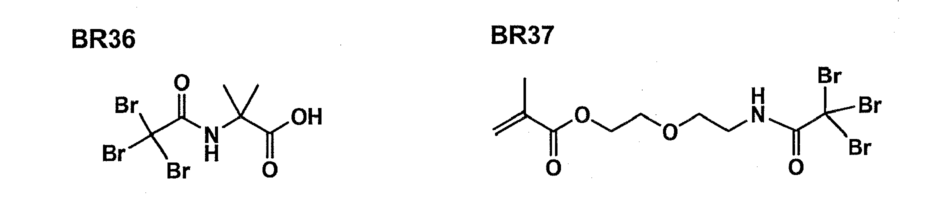

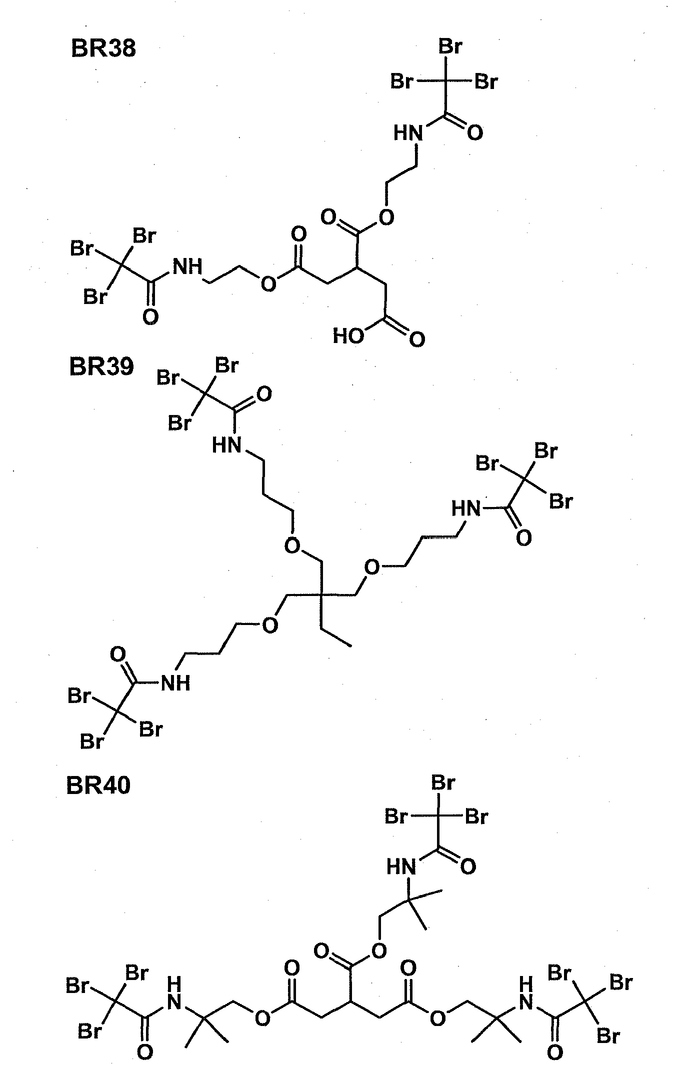

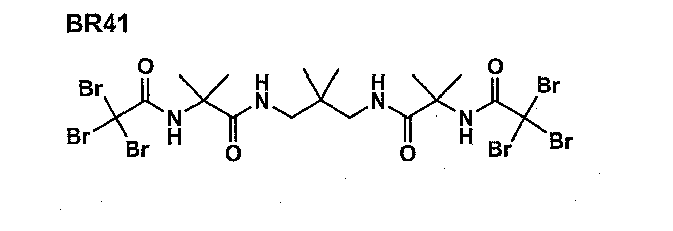

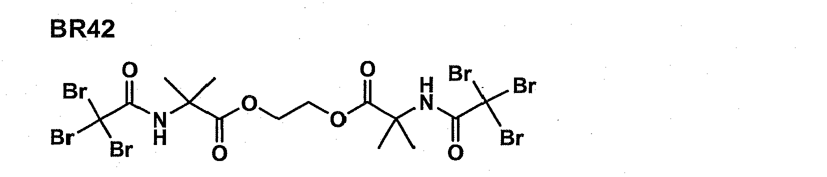

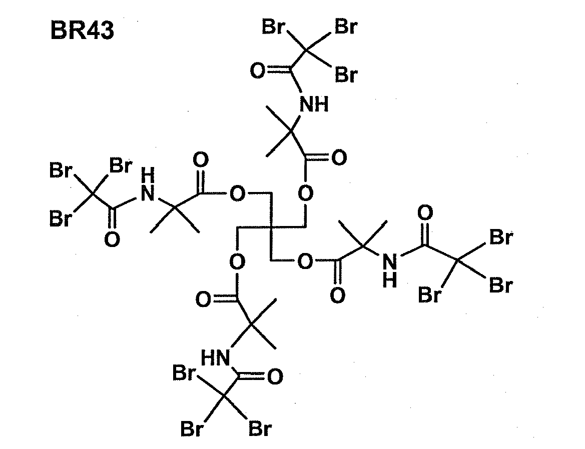

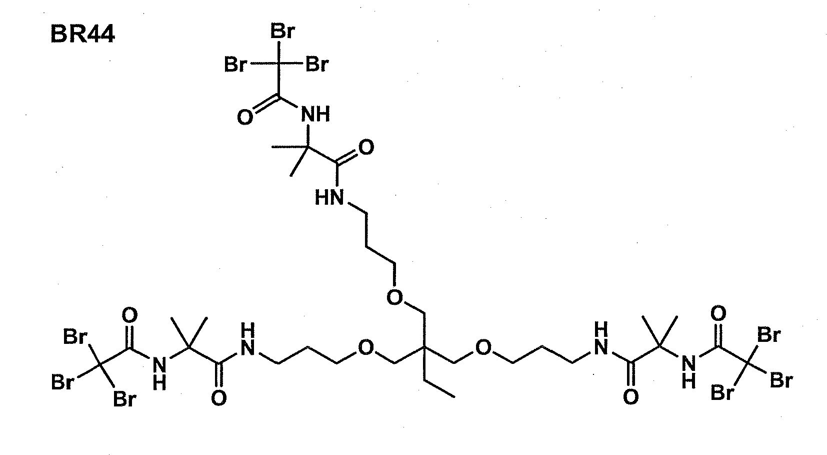

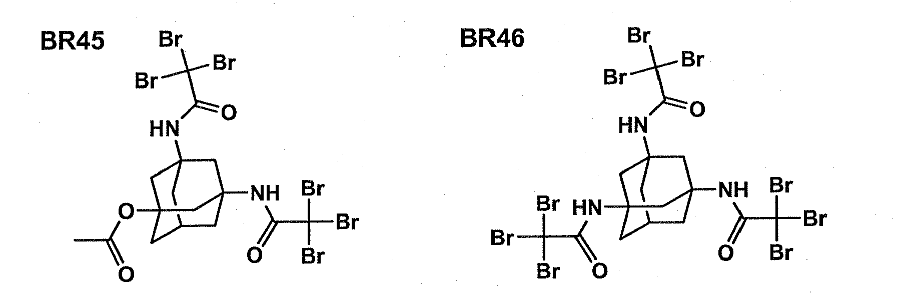

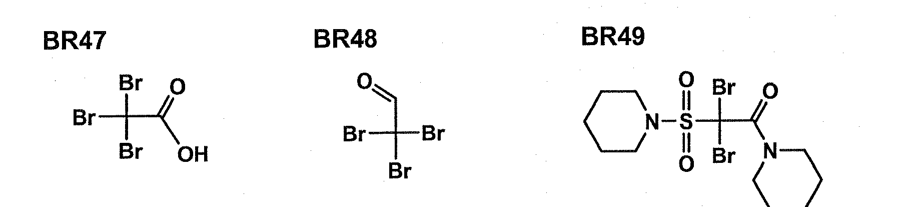

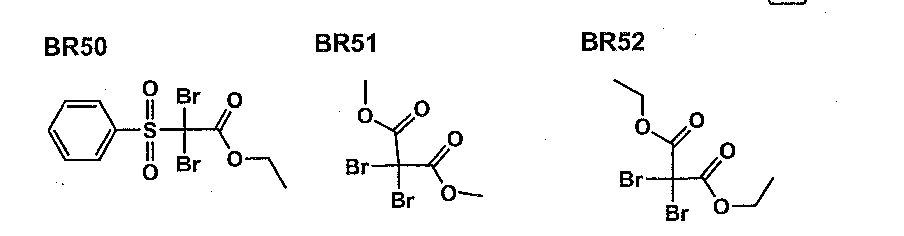

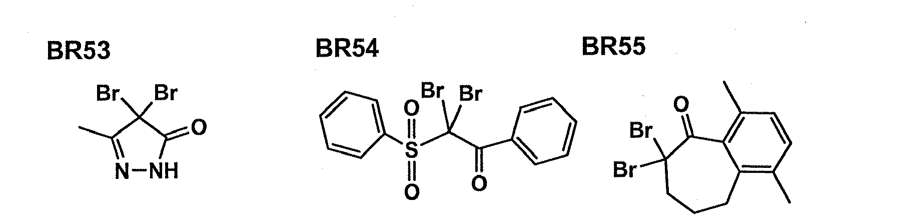

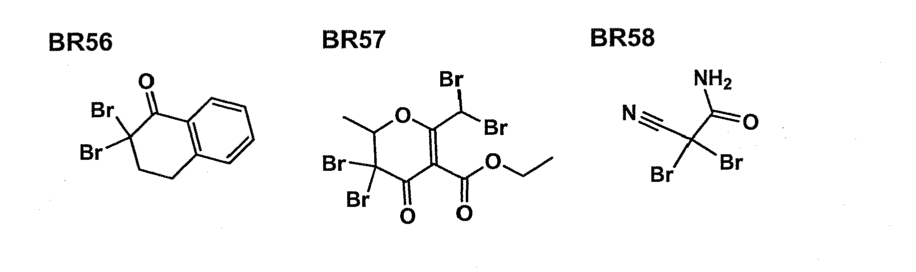

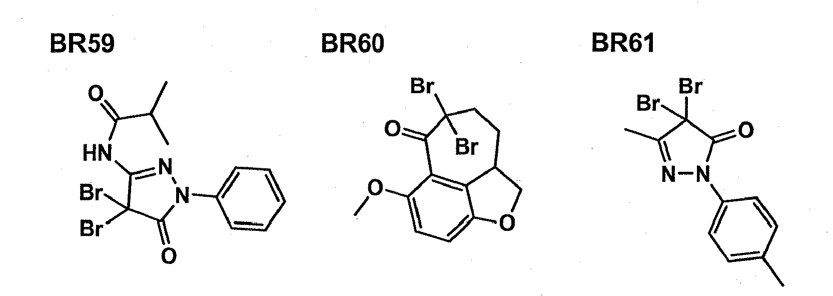

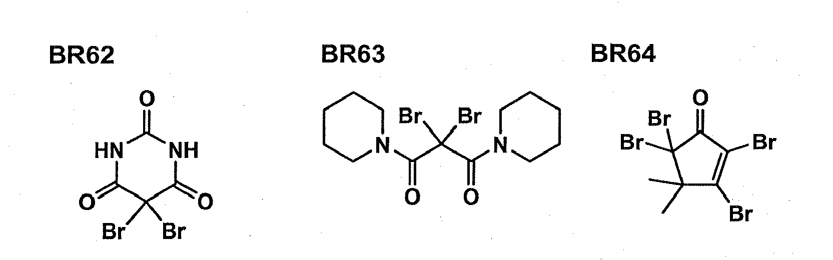

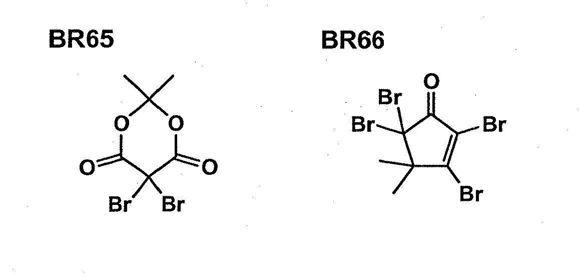

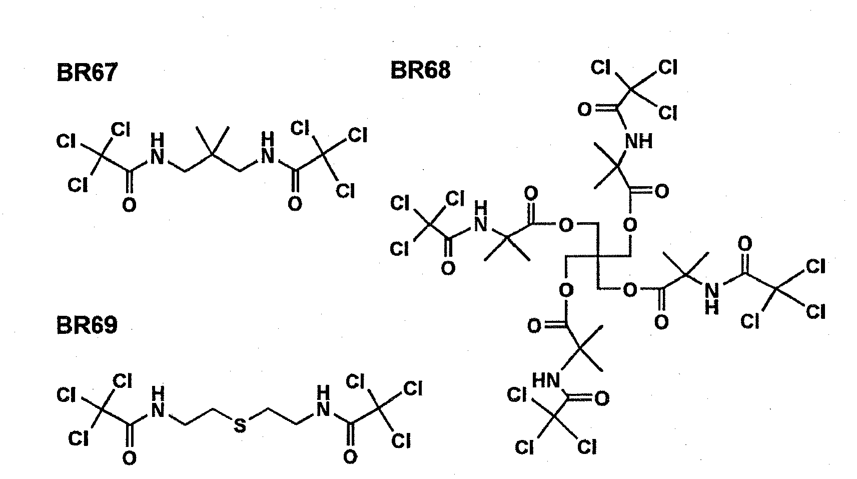

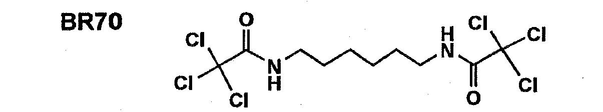

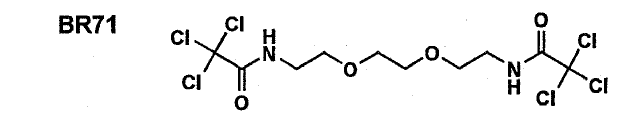

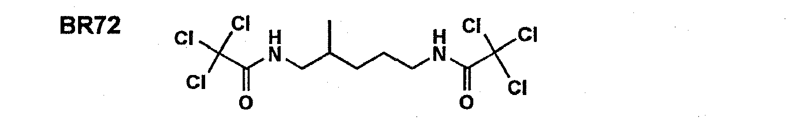

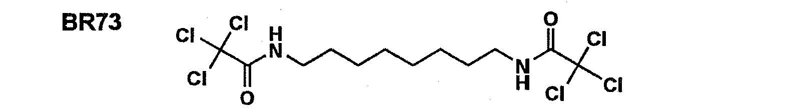

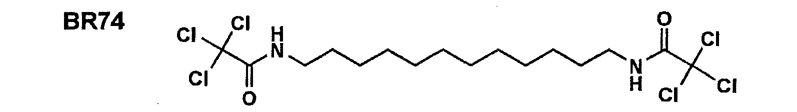

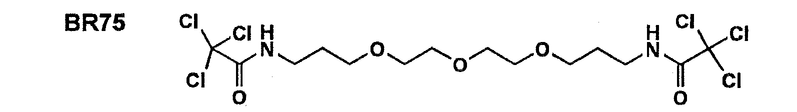

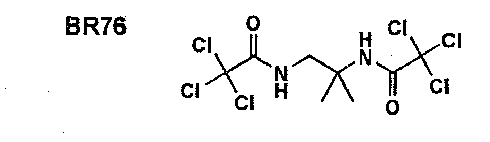

Preferred examples of compounds represented by formula (PH5) are compounds BR 2 through BR 47, and BR 67 through BR 76 exemplified above.

Among polyhalogen compounds represented by formulas (PH1) through (PH5), polybromine compounds are preferred.

As a polyhalogen compound, a trihalomethyl triazine compound is preferably used in the invention. Listed are, for example, compounds described in Bull. Chem. Soc. Japan, 42, 2924 (1969), by Wakabayashi et. al., such as 2-phenyl-4,6-bis(trichloromethyl)-s-triazine, 2-(p-chlorophenyl)-4,6-bis(trichloromethyl)-s-triazine, 2-(p-tolyl)-4,6-bis(trichloromethyl)-s-triazine, 2-(p-methoxyphenyl)-4,6-bis(trichloromethyl)-s-triazine, 2-(2',4'-dichlorophenyl)-4,6-bis(trichloromethyl)-s-triazine, 2,4,6-tris(trichloromethyl)-s-triazine, 2-methyl-4,6-bis(trichloromethyl)-s-triazine, 2-n-nonyl-4,6-bis(trichloromethyl)-s-triazine and 2-(α,α,β-trichloroethyl)-4,6-bis(trichloromethyl)-s-triazine. In addition to this, listed are compounds described in BP No. 1388492, for example, such as 2-styryl-4,6-bis(trichloromethyl)-s-triazine, 2-(p-methylstyryl)-4,6-bis(trichloromethyl)-s-triazine, 2-(p-methoxystyryl)-4,6-bis(trichloromethyl)-s-triazine and 2-(p-methoxystyryl)-4-amino-6-trichloromethyl-s-triazine; compounds described in JP-A No. 53-133428, for example, such as 2-(4-methoxy-naphtho-1-yl)-4,6-bis(trichloromethyl)-s-triazine, 2-(4-ethoxy-naphtho-1-yl)-4,6-bis(trichloromethyl)-s-triazine, 2-[4-(2-ethoxyethyl)-naphtho-1-yl]-4,6-bis(trichloromethyl)-s-triazine, 2-[4,7-dimethoxy-naphtho-1-yl]-4,6-bis(trichloromethyl)-s-triazine and 2-(acetonaphtho-5-yl)-4,6-bis(trichloromethyl)-s-triazine; and compounds described in German Patent No. 3337024.

Further, listed are compounds described in J. Org. Chem., 29, 1527(1964) by F. C. Schaefer et. al., for example, such as 2-methyl-4,6-bis(tribromomethyl)-s-triazine, 2,4,6-tris(tribromomethyl)-s-triazine, 2,4,6-tris(dibromomethyl)-s-triazine, 2-amino-4-methyl-6-tribromomethyl-s-triazine and 2-methoxy-4-methyl-6-trichloromethyl-s-triazine.

### (Boron compound)

As the polymerization initiator in the invention, a boron compound, particularly a monoalkyltriaryl borate described below is preferably used in addition to the polymerization initiator described above.

As the monoalkyltriaryl borate, there are those described in Japanese Patent O.P.I. Publication Nos. 62-150242 and 62-143044. Preferred examples of the monoalkyltriaryl borate compounds include tetra-n-butyl ammonium n-butyltrinaphthalene-1-yl-borate, tetra-n-butylammonium n-butyltriphenylborate, tetra-n-butylammonium triphenyl-mono-t-butylborate, tetra-n-butylammonium n-butyl-tri-(4-tert-butylphenyl)borate, tetra-n-butylammonium n-hexyl-tri-(3-chloro-4-methylphenyl)borate, and tetra-n-butylammonium n-hexyl-tri-(3-fluorophenyl)borate.

### (Hexaaryl bisimidazole)

In the invention, preferred polymerization initiators are hexaarylbisimidazoles and their derivatives. The synthetic method of the hexaarylbisimidazoles (HABI, dimmers of triarylimidazoles) is disclosed in DIELECTRIC 1470154, and use thereof in a photopolymerizable composition is disclosed in EP 24629, EP 107792, US 4410621, EP 215453 and DIELECTRIC 321312.

Preferred examples of the hexaarylbisimidazoles include 2, 4, 5, 2', 4', 5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbisimidazole, 2,2'-bis(2,4-dichlorophenyl)-4,5,4',5'-tetraphenylbisimidazole, 2,2'-bis(2-chlorophenyl)-4,5,4',5'-tetrakis(3-methoxyphenyl)bisimidazole, 2,2'-bis(2-chlorophenyl)-4,5,4',5'-tetrakis(3,4,5-trimethoxyphenyl)bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbisimidazole, 2,2'-di-o-tolyl-4,5,4',5'-tetraphenylbisimidazole, 2,2'-bis(2-ethoxyphenyl)-4,5,4',5'-tetraphenylbisimidazole, and 2,2'-bis(2,6-difluorophenyl)-4,5,4',5'-tetraphenylbisimidazole.

These hexaarylbisimidazoles can be used in combination with other bisimidazoles as necessary. The bisimidazole compounds can be easily synthesized according to a method disclosed in for example, Bull. Chem. Soc. Japan, 33, 565 (1960) or J. Org. Chem. 36[16], 2262 (1971). The content of the hexaaryl bisimidazole or its derivative in the light-sensitive layer is not specifically limited, but is preferably from 0.1 to 20% by weight, and more preferably from 0.8 to 15% by weight.

In the invention, the polymerization initiator is preferably a bisimidazole compound, a boron compound or a polyhalogen compound. The content of the polymerization initiator in the light-sensitive layer is not specifically limited, but is preferably from 0.1 to 20% by weight, and more preferably from 0.8 to 15% by weight.

As the polymerization initiator used in the invention, there are carbonyl compounds, organic sulfur compounds, peroxides, redox compounds, azo or diazo compounds, halides and photo-reducing dyes disclosed in J. Kosar, "Light Sensitive Systems", Paragraph 5, and those disclosed in British Patent No. 1,459,563. Typical examples of the photopolymerization initiator used in combination include the following compounds: a benzoin derivative such as benzoin methyl ether, benzoin i-propyl ether, or α,α-dimethoxy-α-phenylacetophenone; a benzophenone derivative such as benzophenone, 2,4-dichlorobenzophenone, o-benzoyl methyl benzoate, or 4,4'-bis (dimethylamino) benzophenone; a thioxanthone derivative such as 2-chlorothioxanthone, 2-i-propylthioxanthone; an anthraquinone derivative such as 2-chloroanthraquinone or 2-methylanthraquinone; an acridone derivative such as N-methylacridone or N-butylacridone; α,α-diethoxyacetophenone; benzil; fluorenone; xanthone; an uranyl compound; a triazine derivative disclosed in Japanese Patent Publication Nos. 59-1281 and 61-9621 and Japanese Patent O.P.I. Publication No. 60-60104; an organic peroxide compound disclosed in Japanese Patent O.P.I. Publication Nos. 59-1504 and 61-243807; a diazonium compound in Japanese Patent Publication Nos. 43-23684, 44-6413, 47-1604 and US Patent No. 3,567,453; an organic azide compound disclosed in US Patent Nos. 2,848,328, 2,852,379 and 2,940,853; orthoquinondiazide compounds disclosed in Japanese Patent Publication Nos. 36-22062b, 37-13109, 38-18015 and 45-9610.

### (Polymerizable compound)

The polymerizable compound is a compound whose polymerization is initiated by a reaction product produced from a polymerization initiator on light exposure. The polymerizable compound in the invention is a compound whose polymerization is initiated by a radical species generated from the polymerization initiator in the invention on light exposure.

The polymerizable compound used in the invention is preferably a compound having an ethylenically double bond (hereinafter also referred to as an ethylenically unsaturated compound). As the ethylenically unsaturated compound, there are a conventional radical polymerizable monomer, and a polyfunctional monomer or oligomer having two or more of an ethylenic double bond in the molecule generally used in an ultraviolet curable resin composition.

In the invention, the content of the polymerizable compound in the light sensitive layer is preferably from 1 to 70% by weight, more preferably from 5 to 60% by weight, and more preferably from 10 to 50% by weight.

The ethylenically unsaturated compound is not specifically limited. Preferred examples thereof include a monofunctional acrylate such as 2-ethylhexyl acrylate, 2-hydroxypropyl acrylate, glycerol acrylate, tetrahydrofurfuryl acrylate, phenoxyethyl acrylate, nonylphenoxyethyl acrylate, tetrahydrofurfuryl-oxyethyl acrylate, tetrahydrofurfuryloxyhexanorideacrylate, an ester of 1,3-dioxane-s-caprolactone adduct with acrylic acid, or 1,3-dioxolane acrylate; a methacrylate, itaconate, crotonate or maleate alternative of the above acrylate; a bifunctional acrylate such as ethyleneglycol diacrylate, triethyleneglycol diacrylate, pentaerythritol diacrylate, hydroquinone diacrylate, resorcin diacrylate, hexanediol diacrylate, neopentyl glycol diacrylate, tripropylene glycol diacrylate, hydroxypivalic acid neopentyl glycol diacrylate, neopentyl glycol adipate diacrylate, diacrylate of hydroxypivalic acid neopentyl glycol-ε-caprolactone adduct, 2-(2-hydroxy-1,1-dimethylethyl)-5-hydroxymethyl-5-ethyl-1,3-dioxane diacrylate, tricyclodecanedimethylol acrylate, tricyclodecanedimethylol acrylate-ε-caprolactone adduct or 1,6-hexanediol diglycidylether diacrylate; a dimethacrylate, diitaconate, dicrotonate or dimaleate alternative of the above diacrylate; a polyfunctional acrylate such as trimethylolpropane triacrylate, ditrimethylolpropane tetraacrylate, trimethylolethane triacrylate, pentaerythritol triacrylate, pentaerythritol tetraacrylate, dipentaerythritol tetraacrylate, dipentaerythritol pentaacrylate, dipentaerythritol hexacrylate, dipentaerythritol hexacrylate-ε-caprolactone adduct, pyrrogallol triacrylate, propionic acid dipentaerythritol triacrylate, propionic acid dipentaerythritol tetraacrylate or hydroxypivalylaldehyde modified dimethylolpropane triacrylate; a methacrylate, itaconate, crotonate or maleate alternative of the above polyfunctional acrylate.

Prepolymers can be used, and as the prepolymers, there can be used a compound described later and a prepolymer to which photopolymerization property is given by incorporating an acryloyl or methacryloyl group into an oligomer having an appropriate molecular weight. These prepolymers can be used singly, in combination, or as an admixture thereof with the above described monomers and/or oligomers.

Examples of the prepolymer include polyester (meth)acrylate obtained by incorporating (meth)acrylic acid in a polyester of a polybasic acid such as adipic acid, trimellitic acid, maleic acid, phthalic acid, terephthalic acid, hymic acid, malonic acid, succinic acid, glutaric acid, itaconic acid, pyromellitic acid, fumalic acid, pimelic acid, sebatic acid, dodecanic acid or tetrahydrophthalic acid with a polyol such as ethylene glycol, ethylene glycol, diethylene glycol, propylene oxide, 1,4-butane diol, triethylene glycol, tetraethylene glycol, polyethylene glycol, grycerin, trimethylol propane, pentaerythritol, sorbitol, 1,6-hexanediol or 1,2,6-hexanetriol; an epoxyacrylate such as bisphenol A-epichlorhydrin-(meth)acrylic acid or phenol novolak · epichlorhydrin · (meth)acrylic acid obtained by incorporating (meth)acrylic acid in an epoxy resin; an urethaneacrylate such as ethylene glycol·adipic acid·tolylenediisocyanate·2-hydroxyethylacrylate, polyethylene glycol·tolylenediisocyanate·2-hydroxyethylacrylate, hydroxyethylphthalyl methacrylate·xylenediisocyanate, 1,2-polybutadieneglycol·tolylenediisocyanate·2-hydroxyethylacrylate or trimethylolpropane·propylene glycol·tolylenediisocyanate·2-hydroxyethylacrylate, obtained by incorporating (meth)acrylic acid in an urethane resin; a silicone acrylate such as polysiloxane acrylate, or polysiloxane-diisocyanate-2-hydroxyethylacrylate; an alkyd modified acrylate obtained by incorporating a methacroyl group in an oil modified alkyd resin; and a spiran resin acrylate.

The light sensitive layer in the invention may contain a monomer such as a phosphazene monomer, triethylene glycol, an EO modified isocyanuric acid diacrylate, an EO modified isocyanuric acid triacrylate, dimethyloltricyclodecane diacrylate, trimethylolpropane acrylate benzoate, an alkylene glycol acrylate, or a urethane modified acrylate, or an addition polymerizable oligomer or prepolymer having a structural unit derived from the above monomer.

As the ethylenically unsaturated compound used, there is a phosphate compound having at least one (meth)acryloyl group. The phosphate compound is a compound having a (meth)acryloyl group in which at least one hydroxyl group of phosphoric acid is esterified, but is not specifically limited as long as it has a (meth)acryloyl group.

Besides the above compounds, compounds disclosed in Japanese Patent O.P.I. Publication Nos. 58-212994, 61-6649, 62-46688, 62-48589, 62-173295, 62-187092, 63-67189, and 1-244891, compounds described on pages 286 to 294 of "11290 Chemical Compounds" edited by Kagakukogyo Nipposha, and compounds described on pages 11 to 65 of "UV·EB Koka Handbook (Materials)" edited by Kobunshi Kankokai can be suitably used. Of these compounds, compounds having two or more acryl or methacryl groups in the molecule are preferable, and those having a molecular weight of not more than 10,000, and preferably not more than 5,000 are more preferable.

In the invention, an addition polymerizable ethylenically unsaturated monomer having a tertiary amino group in the molecule is preferably used. Its molecular structure is not limited, but those are preferred in which a tertiary amine having a hydroxyl group is modified with glycidyl methacrylate, methacrylic chloride, or acrylic chloride. Examples thereof include a polymerizable compound disclosed I Japanese Patent O.P.I. Publication Nos. 1-165613, 1-203413 and 1-197213.

A reaction product of a polyhydric alcohol having a tertiary amino group in the molecule, a diisocyanate and a compound having a hydroxyl group and an addition polymerizable ethylenically double bond in the molecule is preferably used in the invention.

Examples of the polyhydric alcohol having a tertiary amino group in the molecule include triethanolamine, N-methyldiethanolamine, N-ethyldiethanolamine, N-ethyldiethanolamine, N-n-butyldiethanolamine, N-tert-butyldiethanolamine, N,N-di(hydroxyethyl)aniline, N,N, N', N'-tetra-2-hydroxypropylethylenediamine, p-tolyldiethanolamine, N,N, N', N'-tetra-2-hydroxyethylethylenediamine, N,N-bis(2-hydroxypropyl)aniline, allyldiethanolamine, 3-dimethylamino-1,2-propane diol, 3-diethylamino-1,2-propane diol, N,N-di(n-propylamino)-2,3-propane diol, N,N-di(iso-propylamino)-2,3-propane diol, and 3-(N-methyl-N-benzylamino)-1,2-propane diol, but the invention is not specifically limited thereto.

Examples of the diisocyanate include butane-1,4-diisocyanate, hexane-1,6-diisocyanate, 2-methylpentane-1,5-diisocyanate, octane-1,8-diisocyanate, 1,3-diisocyanatomethylcyclohexanone, 2,2,4-trimethylhexane-1,6-diisocyanate, isophorone diisocyanate, 1,2-phenylene diisocyanate, 1,3-phenylene diisocyanate, 1,4-phenylene diisocyanate, tolylene-2,4-diisocyanate, tolylene-2,5-diisocyanate, tolylene-2,6-diisocyanate, 1,3-di(isocyanatomethyl)benzene, and 1,3-bis(1-isocyanato-1-methylethyl)benzene, but the invention is not specifically limited thereto.

The compounds having a hydroxyl group and an addition polymerizable ethylenically double bond in the molecule include compounds MH-1 through MH-13 as listed below, but are not limited thereto.

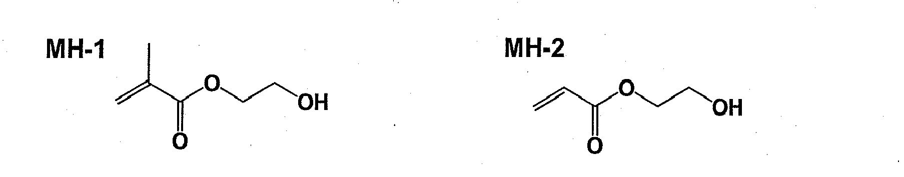

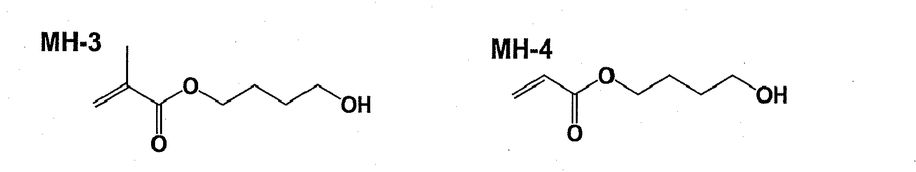

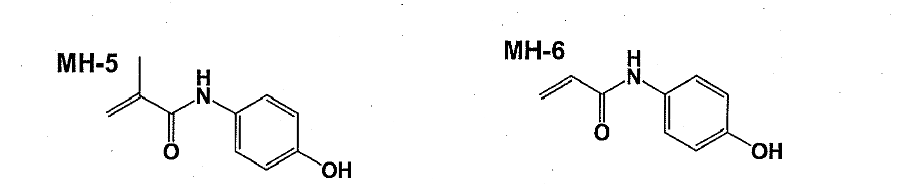

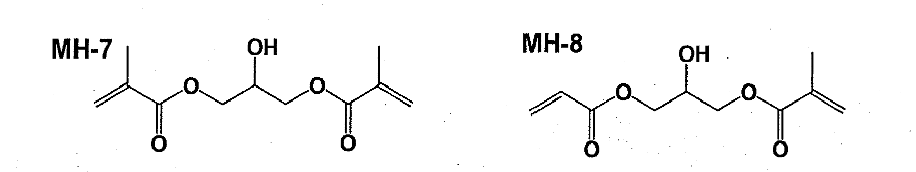

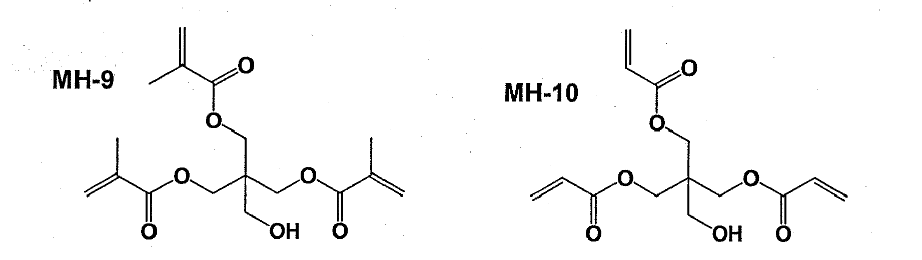

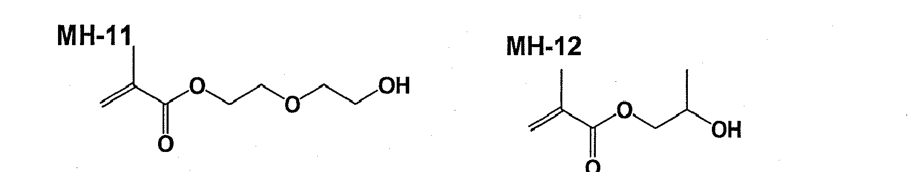

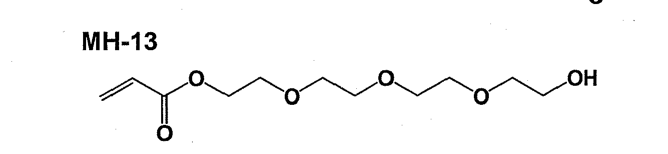

Preferred examples thereof include 2-hydroxyethyl methacrylate, 2-hydroxyethyl acrylate, 4-hydroxybutyl acrylate, 2-hydroxypropylene-1,3-dimethacrylate, and 2-hydroxypropylene-1-methacrylate-3-acrylate.

The reaction product above can be synthesized according to the same method as a conventional method in which a urethane acrylate compound is ordinarily synthesized employing an ordinary diol, a diisocyanate and an acrylate having a hydroxyl group.

Examples of the reaction product of a polyhydric alcohol having a tertiary amino group in the molecule, a diisocyanate and a compound having a hydroxyl group and an addition polymerizable ethylenically double bond in the molecule will be listed below.
M-1: A reaction product of triethanolamine (1 mole), hexane-1,6-diisocyanate (3 moles), and 2-hydroxyethyl methacrylate (3 moles)
M-2: A reaction product of triethanolamine (1 mole), isophorone diisocyanate (3 moles), and 2-hydroxyethyl methacrylate (3 moles)
M-3: A reaction product of N-n-butyldiethanolamine (1 mole), 1,3-bis(1-cyanato-1-methylethyl)benzene (2 moles), and 2-hydroxypropylene-1-methacrylate-3-acrylate (2 moles)
M-4: A reaction product of N-n-butyldiethanolamine (1 mole), 1,3-di(cyanatomethyl)benzene (2 moles), and 2-hydroxypropylene-1-methacrylate-3-acrylate (2 moles)
M-5: A reaction product of N-methydiethanolamine (1 mole), tolylene-2,4-diisocyanate (2 moles), and 2-hydroxypropylene-1,3-dimethacrylate (2 moles)
M-6: A reaction product of triethanolamine (1 mole), 1,3-bis (1-cyanato-1-methylethyl)benzene (3 moles), and 2-hydroxyethyl methacrylate (3 moles)
M-7: A reaction product of ethylenediamine tetraethanol (1 mole), 1,3-bis (1-cyanato-1-methylethyl)benzene (4 moles), and 2-hydroxyethyl methacrylate (4 moles)
M-8: A reaction product of butyldiethanolamine (1 mole), 1,3-bis(1-cyanato-1-methylethyl)benzene (2 moles) and 2-hydroxy-3-acryloyloxypropyl methacrylate (2 moles)

In addition to the above, acrylates or methacrylates disclosed in Japanese Patent O.P.I. Publication Nos. 1-105238 and 2-127404 can be used.

### (Chain transfer agent)

The chain transfer agent is a compound added to a polymerization reaction mixture in order to control polymerization degree of polymer, which has function changing kinds of chain transfer substances in the chain polymerization process.

As the chain transfer agent in the invention, radical chain transfer agents as disclosed in EP 107792 are preferred in promoting or controlling polymerization of the polymerizable compound in the invention. As the preferred chain transfer agent, there is a mercapto compound. It is especially preferred that an aromatic heterocyclic mercapto compound represented by formula (RCT) below or a mercapto derivative compound is contained in the light sensitive layer in the invention.

Formula (RCT) Ar-SM

Wherein M represents a hydrogen atom or an alkali metal atom; and Ar represents an aromatic heterocyclic ring or an aromatic heterocyclic condensed ring each containing in the ring at least one atom selected from the group consisting of a nitrogen atom, a sulfur atom, an oxygen atom, a selenium atom and a tellurium atom. Preferred examples of the aromatic heterocyclic ring or aromatic heterocyclic condensed ring include a benzimidazole ring, a naphthimidazole ring, a benzothiazole ring, a naphthothiazole ring, a benzoxazole ring, a naphthoxazole ring, a benzoselenazole ring, a benzotellurazole ring, an imidazole ring, an oxazole ring, a pyrazole ring, a triazole ring, a triazine ring, a pyrimidine ring, a pyridazine ring, a pyrazine ring, a pyridine ring, a purine ring, a quinoline ring, and a quinazoline ring. An aromatic heterocyclic mercapto compound having a chemical structure other than the aforementioned may be used as the chain transfer agent in the invention.

Various additives which can be contained in the light sensitive layer, a support, a protective layer, a coating method of a light sensitive layer coating liquid on the support and a manufacturing method of a light sensitive planographic printing plate material will be explained below.

### (Various additives)

The light sensitive layer in the invention is preferably added with a polymerization inhibitor, in order to prevent undesired polymerization of the ethylenically unsaturated monomer during the manufacture or after storage of light sensitive planographic printing plate material.

Examples of the polymerization inhibitor include hydroquinone, p-methoxyphenol, di-t-butyl-p-cresol, pyrrogallol, t-butylcatechol, benzoquinone, 4,4'-thiobis (3-methyl-6-t-butylphenol), 2,2'-methylenebis (4-methyl-6-t-butylphenol), N-nitrosophenylhydroxylamine cerous salt, and 2-t-butyl-6-(3-t-butyl-6-hydroxy-5-mrthylbenzyl)-4-methylphenyl acrylate.

The polymerization inhibitor content is preferably 0.01 to 5% by weight based on the total solid content of the light sensitive layer. Further, in order to prevent undesired polymerization induced by oxygen, behenic acid or a higher fatty acid derivative such as behenic amide may be added to the layer. After the light sensitive layer is coated layer, the coated layer may be dried so that the higher fatty acid derivative is localized at the vicinity of the surface of the light sensitive layer. The content of the higher fatty acid derivative is preferably 0.5 to 10% by weight, based on the total solid content of the light sensitive layer.

A colorant can be also used. As the colorant can be used known materials including commercially available materials. Examples of the colorant include those described in revised edition "Ganryo Binran", edited by Nippon Ganryo Gijutu Kyoukai (publishe by Seibunndou Sinkosha), or "Color Index Binran". Pigment is preferred.

Kinds of the pigment include black pigment, yellow pigment, red pigment, brown pigment, violet pigment, blue pigment, green pigment, fluorescent pigment, and metal powder pigment. Examples of the pigment include inorganic pigment (such as titanium dioxide, carbon black, graphite, zinc oxide, Prussian blue, cadmium sulfide, iron oxide, or chromate of lead, zinc, barium or calcium); and organic pigment (such as azo pigment, thioindigo pigment, anthraquinone pigment, anthanthrone pigment, triphenedioxazine pigment, vat dye pigment, phthalocyanine pigment or its derivative, or quinacridone pigment).

Among these pigment, pigment is preferably used which does not substantially have absorption in the absorption wavelength regions of a spectral sensitizing dye used according to a laser for exposure. The absorption of the pigment used is not more than 0.05, obtained from the reflection spectrum of the pigment measured employing an integrating sphere and employing light with the wavelength of the laser used. The pigment content is preferably 0.1 to 10% by weight, and more preferably 0.2 to 5% by weight, based on the total solid content of the photopolymerizable light sensitive layer composition.

A purple pigment or a blue pigment is preferably utilized in view of absorption of light with the aforesaid photosensitive wavelength region and image visibility after development. Such pigments include, for example, Cobalt Blue, cerulean blue, Alkali Blue, Phonatone Blue 6G, Victoria Blue Lake, metal-free Phthalocyanine Blue, Phthalocyanine Fast Sky Blue, Indathrene Blue, indigo, Dioxane Violet, Isoviolanthrone Violet, Indanthrone Blue and Indanthrone BC. Among them, more preferable are Phthalocyanine Blue and Dioxane Violet.

### (Surfactant)

The light sensitive layer can contain a surfactant as a coating improving agent as long as the performance of the invention is not jeopardized. As the surfactant, a nonionic surfactant, an anionic surfactant, a cationic surfactant, or a polymeric surfactant can be used. is preferably employed to disperse these heat-melting particles in water. An aqueous dispersion containing these surfactants can be stabilized, providing a uniform coating with no deficiencies.

Preferred examples of the nonionic surfactant include polyoxyethylene adducts such as alkyl polyoxyethylene ether, alkyl polyoxyethylene, polyoxypropylene ether, fatty acid polyoxyethylene ester, fatty acid polyoxyethylene sorbitan ester, fatty acid polyoxyethylene sorbitol ester, polyoxyethylene castor oil, polyoxyethylene adduct of acetylene glycol, and alkyl polyoxyethylene amine or amide; polyols such as fatty acid sorbitan ester, fatty acid polyglycerin ester and fatty acid sucrose ester or alkylolamide; silicon atom-containing surfactants, which are polyether modified, alkyl aralkyl polyether modified, epoxy polyether modified, alcohol modified, fluorine modified, amino modified, mercapto modified, epoxy modified, or allyl modified; fluorine atom-containing surfactants of perfluoroalkyl ethyleneoxide adduct; and others such as lipid-containing material, biosurfactant, or oligo soap. At least one kind of these can be used.

Preferred examples of the cationic surfactant include alkylamine salts or acylamine salts such as primary amine salts, acylaminoethylamine salts, N-alkylpolyalkylene polyamine salts, fatty acid polyethylene polyamide, amides or their salts, or amine salts; quaternary ammonium salts or ammonium salts having an amide bond such as alkyltrimethylammonium salt, dialkyldimethylammonium salt, alkyldimethylbenzyl ammonium salt, alkylpridium salt, acylaminoethylmethyldiethyl ammonium salt, acylaminopropyldimethylbenzyl ammonium salt, acylaminopropyl-diethylhydroxyethyl ammonium salt, acylaminoethyl pyridinium salt, or diacylaminoethyl ammonium salt; ammonium salts having an ester bond or an ether bond such as diacyloxyethylmethylhydroxyethyl ammonium salt or alkyloxymethyl pyridinium salt; imidazolines or imidazolium salts such as alkyl imidazoline, 1-hydroxyethyl-2-alkyl imidazoline, or 1-acylaminoethyl-2-alkylimidazolium salt; amine derivatives such as alkylpolyoxyethylene amine, N-alkylaminopropyl amine, N-acylpolyethylene polyamine, acylpolyethylene polyamine, or fatty acid triethanolamine ester; and others such as lipid-containing material, biosurfactant or oligo soap. At least one kind of these can be used.

Preferred examples of the anionic surfactant include carboxylic acid salts such as fatty acid salt, rosin group, naphthene group, ether carboxylate, alkenyl succinate, N-acyl sarcosine salt, N-acyl glutamate, sulfuric acid primary alkyl salt, sulfuric acid secondary alkyl salt, sulfuric acid alkyl polyoxyethylene salt, sulfuric acid alkylphenyl polyoxyethylene salt, sulfuric acid mono-acyl glycerin salt, acyl amino sulfuric acid ester salt, sulfuric acid oil, or sulfation aliphatic acid alkyl ester; sulfonic acid such as α-olefin sulfonate, secondary alkane sulfonate, α-sulfo aliphatic acid, acyl isethionic acid salt, N-acyl-N-methyl taurine acid, dialkyl sulfo succinate, alkylbenzenesulfonate, alkylnaphthalenesulfonate, alkyl diphenyl ether disulfonate, petroleum sulfonate, or lignin sulfonate; phosphoric ester acid salt such as phosphoric acid alkyl salt or phosphoric acid alkyl polyoxyethylene salt; silicon atom-containing anionic surfactant such as sulfonic acid modified or carboxyl modified; a fluorine-contained surfactant such as perfluoro alkyl carboxylic acid salt, perfluoro alkyl sulfonic acid salt, perfluoro alkyl phosphoric acid ester, or perfluoro alkyl trimethyl ammonium salt; and others such as lipid-containing material, biosurfactant, or oligo soap. At least one kind of these can be used.

Preferred examples of the polymeric surfactant include polymer or copolymer of poly alkyl (meth) acrylic acid such as poly (meth) acrylate, butyl (meth) acrylate acrylic acid copolymer, ethylene-acrylic acid copolymer, or ethylene-methacrylic acid copolymer; maleic acid copolymer such as vinyl acetate-maleic anhydride copolymer, styrene-maleic anhydride copolymer, α-olefin-maleic anhydride copolymer, or diisobutylene-maleic acid copolymer; fumaric acid copolymer such as methyl (meth) acrylate-fumaric acid copolymer or vinyl acetate-fumaric acid copolymer; aromatic sulfonic-acid formalin condensation product such as naphthalene sulfonic acid formalin condensation product, butyl naphthalene sulfonic acid formalin condensation product, or cresol sulfonic-acid formalin condensation product; poly alkyl pyridinium salt (including derivatives of the copolymer obtained via copolymerization with vinyl monomer copolymerized with vinylpyridine) such as poly N-methylvinyl pyridinium chloride, or so forth; polyacrylamide, polyvinyl pyrrolidone, poly acryloyl pyrrolidone, polyvinyl alcohol, polyethylene glycol; block polymer of polyoxyethylene and polyoxypropylene; cellulose derivative such as methylcellulose or carboxymethyl cellulose; and polysaccharide derivative such as poly oxyalkylene polysiloxane copolymer, gum arabic, or arabinogalactan. At least one kind of these can be used. As for the above polymeric surfactant examples, alkali salt such as sodium, potassium, or ammonium may be allowed to be used in place of a polymeric surfactant containing a carboxyl group or a sulfone group.

Among these surfactants, the fluorine-contained surfactant is preferred since its surface orientation in a light sensitive layer increases ink receptivity, and markedly decreases wastes at the beginning of printing.

Further, in order to improve physical properties of the cured light sensitive layer, the layer can contain an inorganic filler or a plasticizer such as dioctyl phthalate, dimethyl phthalate or tricresyl phosphate. The content of such a material is preferably not more than 10% by weight, based on the total solid content of the light sensitive layer. Further, the center-line average surface roughness (Ra) of the light sensitive layer surface is adjusted to be in the range of from 0.1 to 1 *µ*m by addition of particles such as silica particles or cross-linked acryl resin particles, which also decreases wastes at the beginning of printing as addition of the fluorine-contained surfactant. A combination of various techniques described above is preferred.

The solvents used in the preparation of the coating liquid for the light sensitive layer in the invention include an alcohol such as sec-butanol, isobutanol, n-hexanol, or benzyl alcohol; a polyhydric alcohol such as diethylene glycol, triethylene glycol, tetraethylene glycol, or 1,5-pentanediol; an ether such as propylene glycol monobutyl ether, dipropylene glycol monomethyl ether, or tripropylene glycol monomethyl ether; a ketone or aldehyde such as diacetone alcohol, cyclohexanone, or methyl cyclohexanone; and an ester such as ethyl lactate, butyl lactate, diethyl oxalate, or methyl benzoate.

In the above, explanation of a light sensitive layer coating liquid was made. The light sensitive layer in the invention is formed on a support by coating on the support the light sensitive layer coating liquid.

The coating amount of the light sensitive layer is preferably from 0.1 to 10 g/m², and more preferably from 0.5 to 5 g/m².

### (Spectral sensitizing agent)

The spectral sensitizing agent in the invention increases sensitivity of the polymerization initiator on imagewise exposure. In the invention, various spectral sensitizing agents used in the art pertaining to a negative working light sensitive planographic printing plate material can be used according to emission wavelength regions of a light source (such as those of ultraviolet, visible or infrared rays). For example, when a semiconductor laser with high output power is used as a light source, a spectral sensitizing agent is preferably used which absorbs light with the same wavelength regions as the emission wavelength regions of the semiconductor laser.

Examples of the spectral sensitizing agent include optical brightening agents described in JP-A No. 2003-295426, spectral sensitizing agents of JP-A No. 2003-21901, compounds having the structures represented by General Formula (I) of JP-A No. 2003-21895, compounds having the structures represented by General Formula (I) of JP-A No. 21894, spectral sensitizing agents having the specified structures of JA-A No. 2002-351072, spectral sensitizing agents having the specified structures of JP-A No. 2002-351071, spectral sensitizing agents having specified structures (being a pyrrolopyrrole ring) of JP-A No. 2002-351065, spectral sensitizing agents of JP-A No. 2002-268239, spectral sensitizing agents of JP-A No. 2002-268238, spectral sensitizing agents of JP-A No. 2002-268204, compounds having the structures represented by General Formula (I) of JP-A No. 2002-221790, compounds having structures represented by General Formula (I) of JP-A No. 2002-202598, carbazole type spectral sensitizing agents of JP-A No. 2001-042524, spectral sensitizing agents of JP-A No. 2000-309724, spectral sensitizing agents of JP-A No. 2000-258910, naphtho [1,8-bc] furan-5-one derivatives of JP-A No. 2000-206690, merocyanine agents of JP-A No. 2000-147763, and carbonyl compounds of JP-A No. 2000-098605.

As the spectral sensitizing agent in the invention, a spectral sensitizing agent absorbing light having wavelength regions of from 700 to 1200 nm can be used as necessary. Such a spectral sensitizing agent is not specifically limited, and infrared absorbents, light-to-heat conversion materials, near-infrared absorbents, and pigments can be used which are disclosed in US 5340699, Japanese Patent O.P.I. Publication Nos. 2001-175006, 2002-537419, 2002-341519, 2003-76010, 2002-278057, 2003-5363, 2001-125260, 2002-23360, 2002-40638, 2002-62642, and 2002-2787057.

Cyanine dyes, squalirium dyes, oxonol dyes, pyrylium dyes, thiopyrylium dyes, polymethine dyes, oil soluble phthalocyanine dyes, triarylamine dyes, thiazolium dyes, oxazolium dyes, polyaniline dyes, polypyrrole dyes and polythiophene dyes are preferably used.

Besides the above, pigments such as carbon black, titanium black, iron oxide powder, and colloidal silver can be preferably used. Cyanine dyes as dyes, and carbon black as pigments are especially preferred, in view of extinction coefficient, light-to-heat conversion efficiency, and cost.

In addition to the above spectral sensitizing agents, spectral sensitizing agents, which can be used in combination, include cyanine, merocyanine, porphyrin, a spiro compound, ferrocene, fluorene, fulgide, imidazole, perylene, phenazine, phenothiazine, acridine, an azo compound, diphenylmethane, triphenylmethane, triphenylamine, cumarin derivatives, ketocumarin, quinacridone, indigo, styryl, pyrylium compounds, pyrromethene compounds, pyrazolotriazole compounds, benzothiazole compounds, barbituric acid derivatives, thiobarbituric acid derivatives, and ketoalcohol borate complexes.

The content of spectral sensitizing agent in the invention in the light sensitive layer is optional, but is preferably from 0.1 to 20% by weight, and more preferably from 0.8 to 15% by weight. In more detail, when the spectral sensitizing agent in the invention is applied to a light sensitive layer of light sensitive planographic printing plate material, the content of the spectral sensitizing agent in the light sensitive layer added is preferably an amount which provides an absorbance of reflection spectra of preferably from 0.2 to 2.0, and more preferably from 0.3 to 1.2, the absorbance being measured at a wavelength of a laser used, employing an integrating sphere.

These spectral sensitizing dyes can be used solely or in combination thereof.

Preferred examples of the cyanine dyes will be listed below.

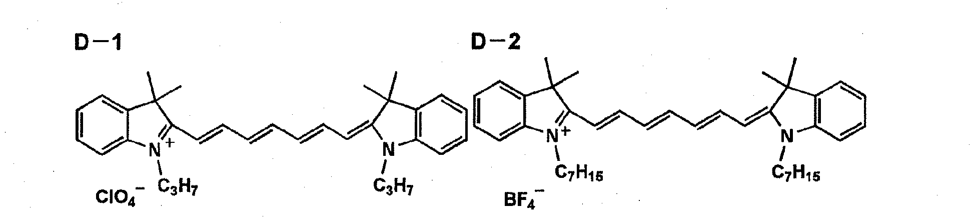

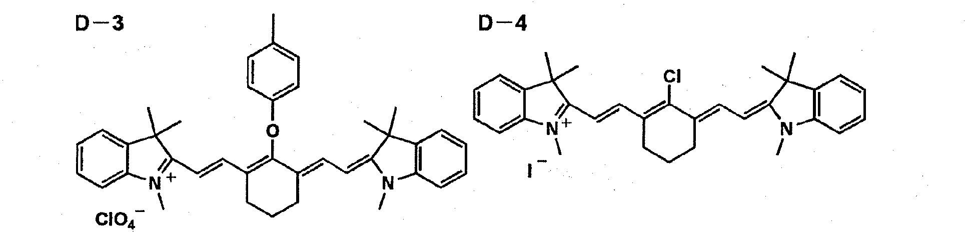

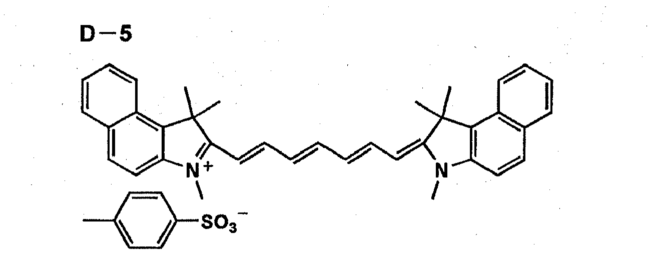

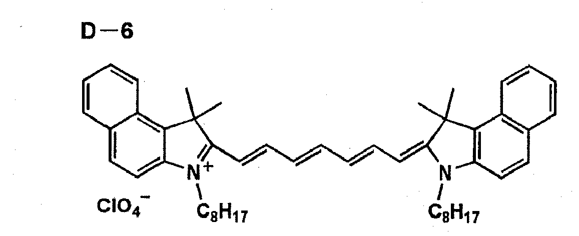

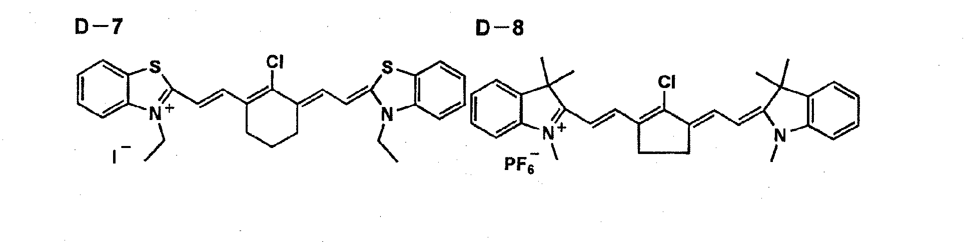

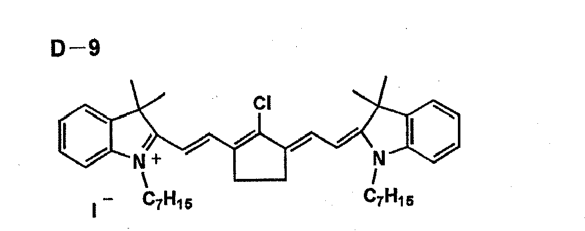

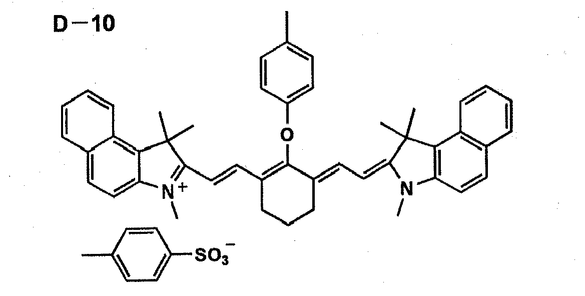

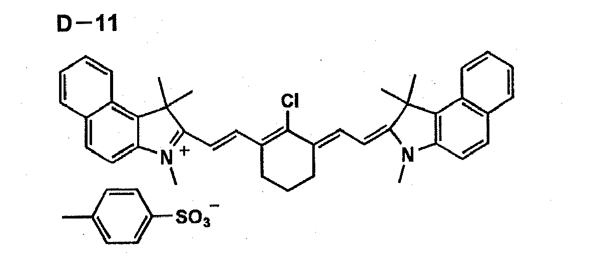

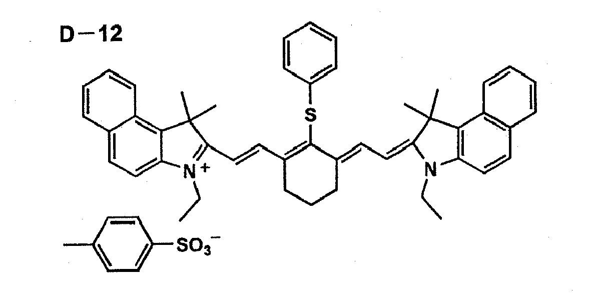

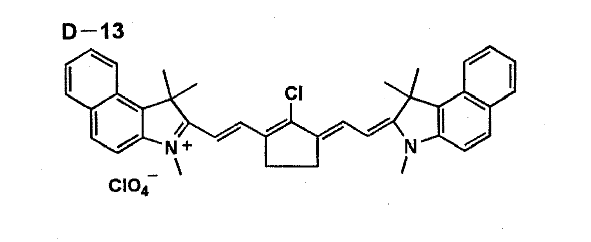

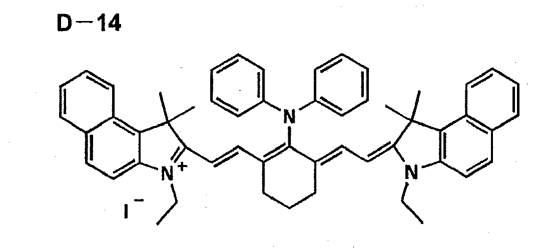

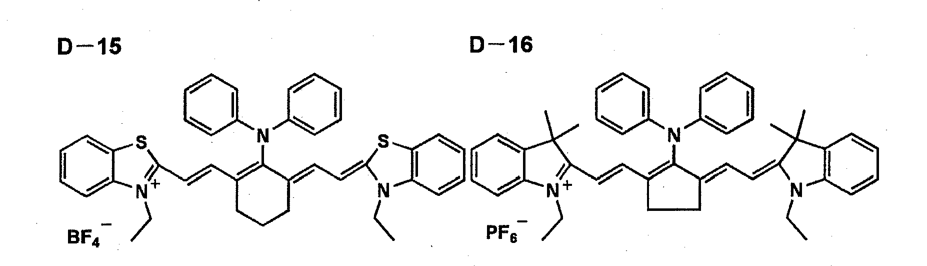

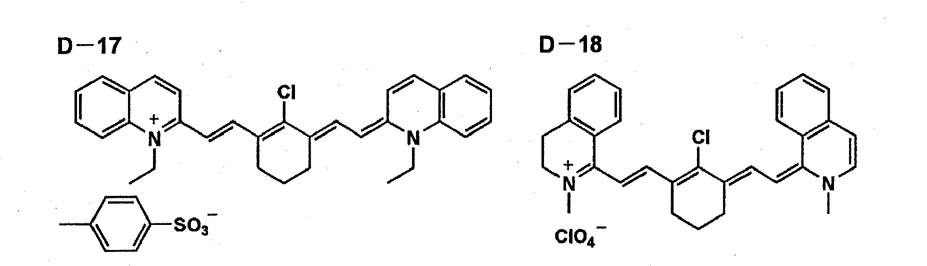

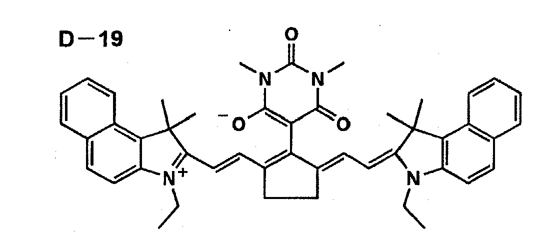

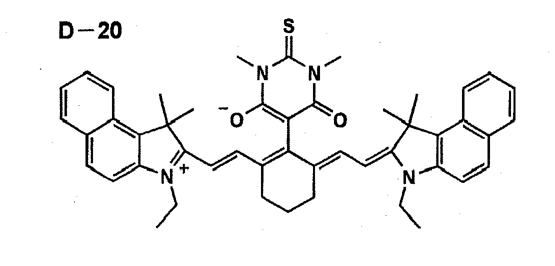

The content in the light sensitive layer of the spectral sensitizing agent absorbing light having wavelength regions of from 700 to 1200 nm differs due to the extinction coefficient of the agent, and is an amount which provides an absorbance at a wavelength of light for exposure of from 0.3 to 3.0, and more preferably from 0.5 to 2.0. For example, the amount described above of cyanine dyes in the light sensitive is about 10 to 100 mg/m².

### (Protective layer)

In the processless printing plate material in the invention, a protective layer is preferably provided on the image formation layer, in order to prevent oxygen transmission and to prevent flaws from occurring during handling. The protective layer may be provided directly on the image formation layer or through an intermediate layer on the image formation layer. It is preferred that the protective layer can be removed on a printing press by water or an aqueous solution, and contains a water soluble resin or a water swellable resin in which a water soluble resin is partly cross-linked.

Preferred examples of the water soluble resin include polyvinyl alcohol and polyvinyl pyrrolidone. Polyvinyl alcohol has the effect of preventing oxygen from transmitting and polyvinyl pyrrolidone has the effect of increasing adhesion between the oxygen shielding layer and the image formation layer.

Besides the above two polymers, the oxygen shielding layer may contain a water soluble polymer such as polysaccharide, polyethylene glycol, gelatin, glue, casein, hydroxyethyl cellulose, carboxymethyl cellulose, methyl cellulose, hydroxyethyl starch, gum arabic, sucrose octacetate, ammonium alginate, sodium alginate, polyvinyl amine, polyethylene oxide, polystyrene sulfonic acid, polyacrylic acid, or a water soluble polyamide.

In the planographic printing plate material in the invention, adhesive strength between the protective layer and the light sensitive layer is preferably not less than 35 mN/mm, more preferably not less than 50 mN/mm, and still more preferably not less than 75 mN/mm. Preferred composition of the protective layer is disclosed in Japanese Patent O.P.I. Publication No. 10-010742.

The adhesive strength can be determined according to the following method. The adhesive tape with a sufficient adhesive force is applied on the protective layer, and then peeled together with the protective layer under the applied tape in the normal direction relative to the protective layer surface. Force necessary to peel the tape together with the protective layer is defined as adhesive strength.

The protective layer may further contain a surfactant or a matting agent. The protective layer is formed, coating on the photopolymerizable light sensitive layer a coating solution in which the above protective layer composition is dissolved in an appropriate coating solvent, and drying. The main solvent of the coating solution is preferably water or an alcohol solvent such as methanol, ethanol, or isopropanol.

The thickness of the protective layer is preferably from 0.1 to 5.0 *µ*m, and more preferably from 0.5 to 3.0 *µ*m.

### (Matting agent)

In the invention, the protective layer preferably contains a matting agent with an average size of from 1 to 20 *µ*m, in order to prevent flaws from occurring while the printing plate material is mounted on a laser apparatus or on a printing press.

The matting agent is preferably inorganic particles having a new Mohs hardness of not less than 5 or an organic matting agent. Examples of the inorganic particles having a new Mohs hardness of not less than 5 include particles of metal oxides (for example, silica, alumina, titania, zirconia, iron oxides, chromium oxide), particles of metal carbides (for example, silicon carbide), boron nitride particles, and diamond particles.

Examples of the organic matting agent include starch described in US Patent No. 2,322,037, starch derivatives described in BE 625,451 and GB 981,198, polyvinyl alcohol described in JP-B-44-3643, polystyrene or polymethacrylate described in CH 330,158, polyacrylonitrile described in US Patent No. 3,079,257, and polycarbonate described in US Patent No. 3,022,169.

The adding amount of the matting agent in the overcoat layer is preferably from 0.1 g to less than 10 g per m².

A coating solution for the protective layer may contain a nonionic surfactant in order to secure uniform coatability of the overcoat layer. Examples of the nonionic surfactant include sorbitan tristearate, sorbitan monopalmitate, sorbitan trioleate, stearic acid monoglyceride, polyoxyethylenenonylphenyl ether, and polyoxyethylenedodecyl ether. The content of the nonionic surfactant is preferably 0.05 to 5% by weight, and more preferably 1 to 3% by weight based on the total solid content of the protective layer.

In the invention, the dry thickness of the protective layer is preferably 0.05 to 1.5 g/m², and more preferably 0.1 to 0.7 g/m². This content range prevents occurrence of staining or scratches or deposition of fingerprints, and minimizes ablation scum without impairing removability of the protective layer.

### (Support)

The support used in the invention is a plate or a sheet capable of carrying the light sensitive layer and preferably has a hydrophilic surface on the side on which the light sensitive layer is to be provided.

As the supports used in the invention, a plate of a metal such as aluminum, stainless steel, chromium or nickel, or a plastic film such as a polyester film, a polyethylene film or a polypropylene film, which is deposited or laminated with the above-described metal can be used. Further, a polyester film, a polyvinyl chloride film or a nylon film whose surface is subjected to hydrophilization treatment can be used. Among the above, the aluminum plate is preferably used, and may be a pure aluminum plate or an aluminum alloy plate.

As the aluminum alloy, there can be used various ones including an alloy of aluminum and a metal such as silicon, copper, manganese, magnesium, chromium, zinc, lead, bismuth, nickel, titanium, sodium or iron. In the aluminum plate for the support, the surface is roughened for water retention.

It is preferable that the aluminum plate is subjected to degreasing treatment for removing rolling oil prior to surface roughening (graining). The degreasing treatments include degreasing treatment employing solvents such as trichlene and thinner, and an emulsion degreasing treatment employing an emulsion such as kerosene or triethanol. It is also possible to use an aqueous alkali solution such as caustic soda for the degreasing treatment. When an aqueous alkali solution such as caustic soda is used for the degreasing treatment, it is possible to remove soils and an oxidized film which can not be removed by the above-mentioned degreasing treatment alone. When an aqueous alkali solution such as caustic soda is used for the degreasing treatment, the resulting support is preferably subjected to desmut treatment in an aqueous solution of an acid such as phosphoric acid, nitric acid, sulfuric acid, chromic acid, or a mixture thereof, since smut is produced on the surface of the support. The surface roughening methods include a mechanical surface roughening method and an electrolytic surface roughening method electrolytically etching the support surface.

Though there is no restriction for the mechanical surface roughening method, a brushing roughening method and a honing roughening method are preferable.

Though there is no restriction for the electrolytic surface roughening method, a method, in which the support is electrolytically surface roughened in an acidic electrolytic solution, is preferred.

After the support has been electrolytically surface roughened, it is preferably dipped in an acid or an aqueous alkali solution in order to remove aluminum dust, etc. produced in the surface of the support. Examples of the acid include sulfuric acid, persulfuric acid, hydrofluoric acid, phosphoric acid, nitric acid and hydrochloric acid, and examples of the alkali include sodium hydroxide and potassium hydroxide. Among those mentioned above, the aqueous alkali solution is preferably used.

The dissolution amount of aluminum in the support surface is preferably 0.5 to 5 g/m². After the support has been dipped in the aqueous alkali solution, it is preferable for the support to be dipped in an acid such as phosphoric acid, nitric acid, sulfuric acid and chromic acid, or in a mixed acid thereof, for neutralization.

The mechanical surface roughening and electrolytic surface roughening may be carried out singly, and the mechanical surface roughening followed by the electrolytic surface roughening may be carried out.

After the surface roughening, anodizing treatment may be carried out. There is no restriction in particular for the method of anodizing treatment used in the invention, and known methods can be used. The anodizing treatment forms an anodization film on the surface of the support.

The support which has been subjected to anodizing treatment is optionally subjected to sealing treatment. For the sealing treatment, it is possible to use known methods using hot water, boiling water, steam, a sodium silicate solution, an aqueous dichromate solution, a nitrite solution and an ammonium acetate solution.

After the above treatment, the support is suitably undercoated with a water soluble resin such as polyvinyl phosphonic acid, a polymer or copolymer having a sulfonic acid in the side chain, or polyacrylic acid; a water soluble metal salt such as zinc borate; a yellow dye; an amine salt; and so on, for hydrophilization treatment. The sol-gel treatment support disclosed in Japanese Patent O.P.I. Publication No. 5-304358, which has a functional group capable of causing addition reaction by radicals as a covalent bond, is suitably used.

### (Coating)

In the invention, the above-described light sensitive layer coating liquid is coated on the support according to a coating conventional method, and dried to obtain a light sensitive planographic printing plate material.

Examples of the coating method include an air doctor coating method, a blade coating method, a wire bar coating method, a knife coating method, a dip coating method, a reverse roll coating method, a gravure coating method, a cast coating method, a curtain coating method, and an extrusion coating method.

A drying temperature of the coated light sensitive layer is preferably from 60 to 160 °C, more preferably from 80 to 140 °C, and still more preferably from 90 to 120 °C.

### (Imagewise exposure)

As a light source for recording an image on the light sensitive planographic printing plate material of the invention, various light sources can be used according to light sensitive wavelength regions of the planographic printing plate material, and a laser is preferably used.

A printing plate is prepared by exposing the light sensitive layer of the printing plate material to laser light according to image information to form an image.

When a laser is used for exposure, which can be condensed in the beam form, scanning exposure according to an image can be carried out, and direct writing is possible without using any mask material. When the laser is employed for imagewise exposure, a highly dissolved image can be obtained, since it is easy to condense its exposure spot in minute size.

As the laser for imagewise exposing the light sensitive planographic printing plate material of the invention, there is a laser emitting infrared or near-infrared light, i.e., light with a wavelength of from 700 to 1500 nm. Preferred examples thereof include a YAG laser and a semiconductor laser. A laser having emission wavelength regions of from 700 to 1200 nm is preferably used in displaying the advantageous effects of the processless planographic printing plate material of the invention.

In a printing process employing the processless printing plate material of the invention, for example, the planographic printing plate material is provided along the outer peripheral wall of the drum of a printing press, and subjected to scanning exposure in the rotational direction (in the main scanning direction) of the drum, employing one or several lasers located outside the cylinder, while moving the lasers in the normal direction (in the sub-scanning direction) to the rotational direction of the drum to form an image.

As the light source, lasers having an emission wavelength regions of from ultraviolet to short visible wavelength regions can be used. Examples of such lasers include a He-Cd laser (441 nm), a combination of Cr:LiSAF and SHG crystals (430 nm) as a solid laser, and Knb03, ring resonator (430 nm), AlGaInN (350-350 nm) or AlGaInN semiconductor laser (InGaN type semiconductor laser available on the market, 400-410 nm) as a semiconductor type laser.

As a laser scanning method of lasers used in the invention, there are a method of laser scanning on an outer surface of a cylinder, a method of laser scanning on an inner surface of a cylinder and a method of laser scanning on a plane. In the method of laser scanning on an outer surface of a cylinder, laser beam exposure is conducted while a drum around which a recording material is wound is rotated, in which main scanning is represented by the rotation of the drum, while sub-scanning is represented by the movement of the laser beam. In the method of laser scanning on an inner surface of a cylinder, a recording material is fixed on the inner surface of a drum, a laser beam is emitted from the inside, and main scanning is carried out in the circumferential direction by rotating a part of or an entire part of an optical system, while sub-scanning is carried out in the axial direction by moving straight a part of or an entire part of the optical system in parallel with a shaft of the drum. In the method of laser scanning on a plane, main scanning by means of a laser beam is carried out through a combination of a polygon mirror, a galvano mirror and an Fθ lens, and sub-scanning is carried out moving a recording medium. The cylinder outer surface laser scanning method and the cylinder inner surface laser scanning method are suitable for high density image recording, since it is easier to increase accuracy of an optical system. The cylinder outer surface laser scanning method is especially preferred in employing laser energy effectively, and in designing easily the optical system including the laser used.

In the invention, imagewise exposure is carried out at a plate surface energy (an exposure energy at the surface of the planographic printing plate material) of from 10 to 500 mJ/cm², and more preferably from 10 to 300 mJ/cm². This exposure energy can be measured, employing a laser power meter PDGDO-3W produced by Ophir Optronics Inc.

### (Processless printing plate material)

The negative working light sensitive planographic printing plate material of the invention can be subjected to conventional development, but is preferably used as a processless printing plate material. Next, a printing process will be explained which employs, as the processless printing plate material, the light sensitive planographic printing plate material of the invention.

### (Image formation)

The processless printing plate material, comprising a light sensitive layer on the hydrophilic surface of the hydrophilic support, has property that after image recording, printing can be carried out without a special development process. After the printing plate material is imagewise exposed and mounted on a plate cylinder of a printing press, or after the printing plate material is mounted on the cylinder and then imagewise exposed, a dampening solution supply roller and/or an ink supply roller are brought into contact with the surface of the resulting printing plate material while rotating the plate cylinder to remove a light sensitive layer at non-image portions and prepare a printing plate on the plate cylinder. Removal of the light sensitive layer at non-image portions after imagewise exposure (so-called on-press development) is carried out on the plate cylinder in the same sequences as in a printing process employing conventional PS plates.

### (Dampening solution)

In the printing process of the invention employing a processless planographic printing plate material, a dampening solution, which is supplied to the printing plate material through a dampening solution supply roller, contains an aqueous solution containing various components, but the dampening solution in the invention is preferably a dampening solution containing a phosphorous compound in an amount of 0.005 to less than 0.04 mol per liter of dampening solution.

In the printing process employing the processless printing plate material of the invention, the dampening solution as described above provides improved ink receptivity at initial printing and improved printing image quality, especially when development on-press is carried out employing a printing plate material employing an aluminum support.

Examples of the phosphorous compound used in the dampening solution in the invention include phosphoric acid or its salt (phosphate), an organophosphorous compound, phosphorous acid or its salt (phosphite), hypophosphorous acid or its salt (hypophosphite), condensed phosphoric acid or its salt, a phytic acid compound, and a phosphonic acid compound.

The phosphate is not specifically limited, as long as it is a compound capable of releasing a phosphate ion in the aqueous solution. Examples thereof include phosphoric acid, phosphoric acid ammonium salts (such as ammonium phosphate, ammonium hydrogen phosphate, or ammonium dihydrogen phosphate), phosphoric acid alkali metal salt (such as sodium phosphate, sodium hydrogen phosphate, sodium dihydrogen phosphate, potassium phosphate), phosphoric acid alkaline earth metal salt (such as zinc phosphate, calcium phosphate, or magnesium phosphate), iron phosphate, manganese phosphate, and phosphomolybdic acid.

Examples of the organophosphorous compound include phenylphosphonic acid, phenylphosphoric acid, naphthylphosphonic acid, naphthylphosphoric acid, glycerophosphonic acid, glycerophosphoric acid, phenylphosphinic acid, naphthylphosphinic acid, diphenylphosphinic acid, dimethylphosphinic acid, p-nitrophenylphosphinic acid, and p-methoxyphenylphosphinic acid.

The phosphite is not specifically limited, as long as it is a compound capable of releasing a phosphite ion in the aqueous solution. Examples thereof include phosphorous acid, ammonium phosphite, sodium phosphite, and potassium phosphite.

The hypophosphite is not specifically limited, as long as it is a compound capable of releasing a hypophosphite ion in the aqueous solution. Examples thereof include hypophosphorous acid, ammonium hypophosphite, sodium hypophosphite, and potassium hypophosphite.

The condensed phosphoric acid salt is not specifically limited, as long as it is compounds capable of releasing a condensed phosphoric acid ion in the aqueous solution. Examples thereof include condensed phosphoric acids such as polyphosphoric acid, pyrophosphoric acid, metaphosphoric acid and ultraphosphoric acid; and their ammonium, alkali metal or alkaline earth metal salts.

The phytic acid compound is not specifically limited, as long as it is a compound capable of releasing a phytic acid ion in the aqueous solution. Examples thereof include phytic acid, and its ammonium, alkali metal or alkaline earth metal salts.

The phosphonic acid compound is not specifically limited, as long as it is a compound capable of releasing a phosphonic acid ion in the aqueous solution. Examples thereof include phosphonic acids such as aminotri(methylenephosphonic acid), 1-hydroxyethylidene-1,1-diphosphonic acid, ethylenediaminetetra(methylenephosphonic acid) and diethylenetriaminepenta(methylenephosphonic acid), and their ammonium or alkali metal salts.

The invention is characterized in that the dampening solution contains the phosphorous compound in an amount of 0.005 to less than 0.04 mol per liter of dampening solution, and preferably from 0.01 to less than 0.04 mol per liter of dampening solution.

When a printing plate material employing an aluminum support is subjected to on-press development, employing a dampening solution having a phosphorous compound content of less than 0.005 mol per liter, lipophilic substances occurring during the development adhere onto the hydrophilic surface at non-image portions of a printing plate, causing problem in initial ink receptivity. That is, stain occurring at non-image portions is difficult to remove, providing insufficient on-press development and resulting in increase of printing paper wastes at initial printing stage. This is because lipophilic substances remain without being removed in pores of the anodization film ordinarily formed on the aluminum support as a hydrophilic layer. However, a dampening solution having a phosphorous compound content of from 0.005 to less than 0.04 mol per liter dissolves the lipophilic substances in the pores together with a part of the anodization layer and removes them from the aluminum support surface. A dampening solution having a phosphorous compound content not less than 0.04 mol per liter is likely to cause stain.

Further, the dampening solution having a phosphorous compound content of 0.005 to less than 0.04 mol per liter provides high image quality in many printed copies without lowering quality of the printed image or dot image, as well as good ink receptivity at initial printing stage, since stain due to lipophilic substances during on-press development is less at non-image portions.

Thus, in a so-called processless printing process comprising on-press development employing a printing plate material comprising a hydrophilic support and a light sensitive layer on the support, the dampening solution having a phosphorous compound content range as described above can provide good ink receptivity at initial printing stage and printed images with high quality.

The dampening solution employed in the invention preferably contains, in addition to a wetting property improving agent (b), at least one selected from a pH adjusting agent (a), a water-soluble polymer (c), a deodorant (d), an antiseptic (e), a chelating agent (f), a colorant (g), (h) an anti-rusting agent and an anti-foaming agent (i). Preferred are a pH adjusting agent (a), a water-soluble polymer (c), and a chelating agent (f). As the pH adjusting agent, at least one selected from water-soluble organic or inorganic acids and their salts can be used. These compounds are effective in adjusting pH of a dampening solution, giving a buffering effect to a dampening solution, appropriately etching a support of a printing plate, and preventing corrosion of the support. Preferred organic acids include citric acid, ascorbic acid, malic acid, tartaric acid, lactic acid, acetic acid, gluconic acid, hydroxyacetic acid, oxalic acid, malonic acid, levulinic acid, sulfanilic acid, and p-toluenesulfonic acid. Examples of the inorganic acids include nitric acid and sulfuric acid. Alkali metal, alkaline earth metal, ammonium or organic amine salts of the organic or inorganic acids can be suitably used. These organic or inorganic acids or their salts may be used singly or as an admixture of two or more kinds thereof.

The content of the pH adjusting agent in the dampening solution is suitably from 0.001 to 0.1% by weight, in preventing stain occurrence during printing and preventing rust of a printing press.

In the invention, pH of the dampening solution is preferably from 4.5 to 8.

Surfactants or specific solvents can be used as the wetting property improving agent (b). Examples of an anionic surfactant of the surfactants include fatty acid salts, abietic acid salts, hydroxyalkanesulfonic acid salts, alkanesulfonic acid salts, dialkylsulfosuccinic acid salts, straight chain alkylbebzenesulfonic acid salts, branched alktlbebzenesulfonic acid salts, alkylnaphthalenesulfonic acid salts, alkylphenoxypolyoxyethylene propylsulfonic acid salts, polyoxyethylene alkylsulfophenyl ether, N-methyl-N-oleyltaurine sodium salts, N-alkylsulfosuccinic acid monoamide disodium salts, petroleum sulfonic acid salts, sulfated castor oil, sulfated tallow oil, fatty acid alkyl ester sulfuric acid ester salts, alkyl sulfate salts, polyoxyethylene alkyl ether sulfuric acid ester salts, fatty acid monoglyceride sulfate ester salts, polyoxyethylene alkylphenyl ether sulfuric acid salts, polyoxyethylene styrylphenyl ether sulfuric acid salts, alkylphosphate ester salts, polyoxyethylene alkyl ether phosphoric acid ester salts, polyoxyethylene alkylphenyl ether phosphoric acid ester salts, partially saponified styrene anhydrous maleic acid copolymer, partially saponified olefin-anhydrous maleic acid copolymer, and naphthalenesulfonic acid salt-formaline condensates. Of the foregoing, dialkylsulfosuccinic acid salts, alkyl sulfate salts and alkylnaphthalenesulfonic acid salts are preferred.

Examples of the cationic surfactant include alkylamine salts or acylamine salts such as primary amine salts, acylaminoethylamine salts, N-alkylpolyalkylene polyamine salts, fatty acid polyethylene polyamide, amides or their salts, or amine salts; quaternary ammonium salts or ammonium salts having an amide bond such as alkyltrimethylammonium salt, dialkyldimethylammonium salt, alkyldimethylbenzyl ammonium salt, alkylpridium salt, acylaminoethylmethyldiethyl ammonium salt, acylaminopropyldimethylbenzyl ammonium salt, acylaminopropyl-diethylhydroxyethyl ammonium salt, acylaminoethyl pyridinium salt, or diacylaminoethyl ammonium salt; ammonium salts having an ester bond or an ether bond such as diacyloxyethylmethylhydroxyethyl ammonium salt or alkyloxymethyl pyridinium salt; imidazolines or imidazolium salts such as alkyl imidazoline, 1-hydroxyethyl-2-alkyl imidazoline, or 1-acylaminoethyl-2-alkylimidazolium salt; amine derivatives such as alkylpolyoxyethylene amine, N-alkylaminopropyl amine, N-acylpolyethylene polyamine, acylpolyethylene polyamine, or fatty acid triethanolamine ester; and others such as lipid-containing material, biosurfactant or oligo soap. At least one kind of these can be used.

Examples of a nonionic surfactant of the surfactants include polyoxyethylene alkyl ethers, polyoxyethylene alkylphenyl ethers, polyoxyethylene polystyrylphenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sugar fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylene-modified caster oils, polyoxyethylene glycerin fatty acid partial esters, fatty acid diethanolamides, N,N-bis-2-hydroxyalkylamines, polyoxyethylene alkylamine, triethanolamine fatty acid esters, polyoxyethylene-polyoxypropylene block polymers, and trialkylamineoxides. Besides the above, fluorine-contained surfactants or silicon-contained surfactants can be also used. The surfactant content of the dampening solution preferably not more than 1% by weight, and more preferably from 0.001 to 0.5% by weight in view of foaming. The surfactants may be used as an admixture of two or more kinds thereof.

Examples of the specific solvents as the wetting property improving agent include ethylene glycol monomethyl ether, diethylene glycol monomethyl ether, triethylene glycol monomethyl ether, tetraethylene glycol monomethyl ether, ethylene glycol monoethyl ether, diethylene glycol monoethyl ether, triethylene glycol monoethyl ether, tetraethylene glycol monoethyl ether, ethylene glycol monopropyl ether, diethylene glycol monopropyl ether, triethylene glycol monopropyl ether, tetraethylene glycol monopropyl ether, ethylene glycol monoisopropyl ether, diethylene glycol monoisopropyl ether, triethylene glycol monoisopropyl ether, tetraethylene glycol monoisopropyl ether, ethylene glycol monobutyl ether, diethylene glycol monobutyl ether, triethylene glycol monobutyl ether, tetraethylene glycol monobutyl ether, ethylene glycol monoisobutyl ether, diethylene glycol monoisobutyl ether, triethylene glycol monoisobutyl ether, tetraethylene glycol monoisobutyl ether, ethylene glycol monotert-butyl ether, diethylene glycol monotert-butyl ether, triethylene glycol monotert-butyl ether, tetraethylene glycol monotert-butyl ether, propylene glycol monomethyl ether, dipropylene glycol monomethyl ether, tripropylene glycol monomethyl ether, propylene glycol monoethyl ether, dipropylene glycol monoethyl ether, tripropylene glycol monoethyl ether, tetrapropylene glycol monoethyl ether, propylene glycol monopropyl ether, dipropylene glycol monopropyl ether, tripropylene glycol monopropyl ether, propylene glycol monoisopropyl ether, dipropylene glycol monoisopropyl ether, tripropylene glycol monoisopropyl ether, dipropylene glycol monobutyl ether, tripropylene glycol monobutyl ether, propylene glycol monoisobutyl ether, dipropylene glycol monoisobutyl ether, tripropylene glycol monoisobutyl ether, propylene glycol monotert-butyl ether, dipropylene glycol monotert-butyl ether, tripropylene glycol monotert-butyl ether, polypropylene glycols having a molecular weight of from 200 to 1000 or their monomethyl, monoethyl, monopropyl, monoisopropyl or monobutyl ether, propylene glycol, dipropylene glycol, tripropylene glycol, tetrapropylene glycol, pentapropylene glycol, ethylene glycol, diethylene glycol, triethylene glycol, butylene glycol, hexylene glycol, 2-ethyl-1,3-hexanediol, 3-methoxy-3-methyl-1-butanol, 1-butoxy-2-propanol, glycerin, diglycerin, polyglycerin, trimethylol propane, 2-pyrrolidones having an alkyl group having a carbon atom number of from 1 to 8 at the 1-position, 3,5-dimethyl-1-hexyne-3-ol, 2,4,7,9-tetramethyl-5-decyne-4,7-diol, propargyl alcohol (2-propyne-1-ol), 3-butyne-1-ol, 1-butyne-3-ol, 2-butyne-1,4-diol, 3,6-dimethyl-4-octyne-3,6-diol.

Among these, ethylene glycol monotert-butyl ether, 3-methoxy-3-methyl-1-butanol and 1-butoxy-2-propanol are especially preferred. These solvents may be used singly or as an admixture of two or more kinds thereof. The content of these solvents in the dampening solution is preferably from 0.002 to 1% by weight, and more preferably from 0.005 to 0.5% by weight.

As the water soluble polymer (c), there are natural products or their modification products such as gum arabic, starch derivatives (for example, dextrin, enzymatic degradation dextrin, hydroxypropylated enzymatic degradation dextrin, carboxymethylated starch, phosphoric acid starch, or octenylsuccinic acid-modified starch), alginates and cellulose derivatives (for example, carboxymethylcellulose, carboxyethylcellulose, methylcellulose, or hydroxyethylcellulose); synthetic products such as polyethylene glycol or its copolymer, polyvinyl alcohol or its copolymer, polyacrylamide or its copolymer, polyacrylic acid or its copolymer, vinyl methyl ether-maleic anhydride copolymer and polystyrene sulfonic acid or its copolymer; and polyvinyl pyrrolidone. Among these, carboxymethylcellulose, and hydroxyethylcellulose are especially preferred. The water soluble polymer content of the dampening solution is preferably from 0.001 to 0.5% by weight, and more preferably from 0.005 to 0.2% by weight.

As the deodorant (d), there are esters ordinarily used as perfumes. Examples thereof include a compound represented by formula (I) below.

Formula (I) R₁-COOR₂

In formula (I), R₁ represents an alkyl group having a carbon atom number of from 1 to 15, an alkenyl group, an aralkyl group, or a phenyl group. The alkyl or alkenyl group has preferably a carbon atom number of from 4 to 8. The alkyl, alkenyl or aralkyl group of R₁ may be straight-chained or branched. The alkenyl group preferably has one double bond. Examples of the aralkyl group include a benzyl group and phenylethyl group. One or more hydrogen atoms of the alkyl, alkenyl, aralkyl or phenyl group may be substituted with a hydroxyl group or an acetyl group. R₂ represents an alkyl group having a carbon atom number of from 3 to 10, an aralkyl group, or a phenyl group, provided that the alkyl or aralkyl group may be straight-chained or branched. The alkyl group has preferably a carbon atom number of from 3 to 9. Examples of the aralkyl group of R₂ include a benzyl group and phenylethyl group.

Examples of the deodorant (d) include esters of formic acid, acetic acid, propionic acid, butyric acid, isobutyric acid, 2-ethylbutyric acid, valeric acid, isovaleric acid, 2-methylvaleric acid, hexanoic acid (caproic acid), 4-methylpentanoic (isohexanoic acid), 2-hexenoic acid, 4-pentenoic acid, heptanoic acid, 2-methylheptanoic acid, octanoic acid (caprylic acid), nonanoic acid, decanoic acid (capric acid), 2-decenoic acid, lauric acid, or myristic acid. In addition to the above, there are benzyl phenylacetate and acetoacetic acid esters such as ethyl acetoacetate or 2-hexyl acetoacetate. Among these, n-pentyl acetate, isopentyl acetate, n-butyl butyrate, n-pentyl butyrate and isopentyl butyrate are preferred, and n-butyl butyrate, n-pentyl butyrate and isopentyl butyrate are more preferred. The content of the deodorant (d) in the dampening solution is preferably from 0.001 to 0.5% by weight, and more preferably from 0.002 to 0.2% by weight. The deodorant can improve working environment. Vanillin or ethylvanillin can be used with the above deodorant.

As the antiseptic (e) used in the dampening solution invention, there are formalin, imidazole derivatives, sodium dehydroacetate, 4-isothiazoline-3-on derivatives, benzotriazole derivatives, amidine or guanidine derivatives, diazine or triazole derivatives, oxazole or oxazine derivatives, and bromonitroalcohols such as bromonitropropanol, 1,1-dibromo-1-nitro-2-ethaol and 3-bromo-3-nitropentane-2,4-diol. The content of the antiseptic (e) in the dampening solution, although different due to kinds of bacteria, mildew or ferment, is an amount effective to the bacteria, mildew or ferment and is preferably from 0.001 to 0.5% by weight. Two or more kinds of the antiseptic effective to bacteria, mildew or ferment are preferably used in combination.

The dampening solution in the invention may contain a chelating agent (f). The dampening solution is ordinarily concentrated, and the concentrated dampening solution is diluted with tap water or well water on using. The calcium ion contained in tap water or well water for diluting has an adverse effect on printing, and may produce stain on printed matter. Addition of the chelating agent to the dampening solution overcomes the above problem. Preferred examples of the chelating agent include ethylenediaminetetracetic acid or its sodium or potassium salt; diethylenetriaminepentacetic acid or its sodium or potassium salt; hydroxyethylethylene-diaminetriacetic acid or its sodium or potassium salt; nitrilotriacetic acid or its sodium salt; organic phosphonic acids or their salts such as 1-hydroxyethane-1,1-diphosphonic acid or its sodium or potassium salt, and aminotri-(methylenephosphonic acid) or its sodium or potassium salt; and phosphonoalkane tricarboxylic acids or their salts. Organic amine salts of the acids mentioned above are also effective. Among these, those, which stably exist in a dampening solution and do not jeopardize printability, are employed. The chelating agent content of the dampening solution is preferably from 0.0001 to 0.5% by weight, and more preferably from 0.0005 to 0.2% by weight.

Colorants (g) used in the dampening solution in the invention are preferably dyes for food. Examples of yellow dyes include CI Nos. 19140, and 15985, examples of red dyes include CI Nos. 16185, 45430, 16255, 45380, and 45100, examples of violet dyes include CI No. 42640, examples of blue dyes include CI Nos. 42090 and 73015, and examples of green dyes include CI No. 42095. The colorant content of the dampening solution is preferably from 0.0001 to 0.5% by weight.

Examples of anti-rusting agent (h) used in the dampening solution in the invention include benzotriazole, 5-methylbenzotriazole, thiosalicylic acid, benzimidazole or their derivative. The anti-foaming agent (i) used in the dampening solution in the invention is preferably a silicon-containing anti-foaming agent, which may be of the emulsion type or of the solution type. The anti-rusting agent content of the dampening solution is preferably from 0.0001 to 0.5% by weight.

The dampening solution in the invention can contain alcohols in order to adjust the surface tension or viscosity and improve the printing performance. Examples of the alcohols include methyl alcohol, ethyl alcohol, propyl alcohol, and isopropyl alcohol.

A constituent other that the components described above of the dampening solution in the invention is water. The dampening solution in the invention contains water in an amount of preferably from 90 to 99.8% by weight, and more preferably from 93 to 99.5% by weight. The dampening solution on the market is ordinarily a concentrated dampening solution. The concentrated dampening solution, which is comprised of the components described above, is prepared by dissolving the above solid components in water, preferably de-ionized water or pure water. The concentrated dampening solution is diluted with tap water or well-water by a factor of 10 to 200 on using.

The dampening solution in the invention can be used both in a conventional dampener and in a continuous feed dampening system, and is used preferably in the continuous feed dampening system. The dampening solution in the invention is applied to Mitsubishi Diamatic Dampener, Komorimatic Dampener, Dahlgren Dampener, or Alcolor Dampener manufactured by Heiderberg Co., Ltd.

### (Ink)

Ink in the invention used in printing may be any ink used in planographic printing. As the ink, there are oily ink comprised of constituents such as a rosin-modified phenol resin, vegetable oil (linseed oil, tung oil, soybean oil, etc.), petroleum solvents, pigment and an oxidative polymerization catalyst (cobalt, manganese, lead, iron, zinc, etc.); UV-curable UV ink comprised of constituent such as acryl oligomers, acryl monomers, a photopolymerization initiator and pigment; and hybrid ink having both properties of oily ink and those of UV ink.

### EXAMPLES

Next, the present invention will be explained below employing examples, but the present invention is not limited thereto. In the examples, "parts" represents "parts by weight", unless otherwise specified.

### Example 1

### (Synthesis 1)

N-Vinyl pyrrolidone of 65.5 parts (0.59 mol%), 100 parts of ethanol and 1.23 parts of α,α'-azobisiso-butylonitrile were placed in a three neck flask under nitrogen atmosphere. The resulting mixture was reacted under nitrogen atmosphere for 6 hours at 80°C in an oil bath, while dropwise adding 35.0 parts (0.41 mol%) of methacrylic acid.

After that, the reaction mixture was added with one part of triethylbenzylammonium chloride and 28 parts (0.2 mol%) of glycidyl methacrylate, and reacted at 25 °C for 3 hours. Thus, Polymer 1 as a polymeric binder was obtained. Polymer 1 had a weight average molecular weight of 55,000, measured according to GPC, and had an acid value of 95.

### (Synthetic 2)

Methyl vinyl ether-maleic anhydride copolymer Gantrez AN-119 (produced by ISP Japan Co., Ltd.) of 64.0 parts (0.82 mol%), 100 parts of isopropanol, 1 part of triethylbenzylammonium chloride, and 28 parts (0.2 mol%) of glycidyl methacrylate were placed in a three neck flask under nitrogen atmosphere, and reacted at 25 °C for 3 hours. Thus, Polymer 7 as a polymeric binder was obtained. Polymer 7 had a weight average molecular weight of 130,000, measured according to GPC, and had an acid value of 90.

Polymers 2 through 6 as shown in Table 1 were prepared in the same manner as above, except that monomers as shown in Table 1 were used. Polymer (P-1) described in Table 1 of Examples of Japanese Patent O.P.I. Publication No. 2002-162741 was synthesized as Comparative polymer 1. Polymer described in Example 1 of Japanese Patent O.P.I. Publication No. 2000-181062 was synthesized as Comparative polymer 2.

**Table 1**

| | N-Vinyl-2-pyrrolidone (mol%) | N-Vinyl-2-caprolactam (mol%) | Methacrylic acid (mol%) | Vinyl acetate (mol%) | Glycidyl methacrylate (mol%) | Acid value | Mw |
|---|---|---|---|---|---|---|---|
| Polymer 1 | 0.59 | | 0.41 | | 0.2 | 95 | 55.000 |
| Polymer 2 | 0.69 | | 0.31 | | 0.2 | 40 | 55.000 |
| Polymer 3 | 0.8 | | 0.2 | | 0.2 | 0 | 55.000 |
| Polymer 4 | 0.39 | | 0.61 | | 0.2 | 210 | 55.000 |
| Polymer 5 | | 0.59 | 0.41 | | 0.2 | 95 | 55.000 |
| Polymer 6 | 0.49 | | 0.41 | 0.1 | 0.2 | 95 | 55.000 |

### (Preparation of support)

A 0.30 mm thick aluminum plate (material 1050, refining H16) was degreased at 65° C for one minute in a 5% sodium hydroxide solution, washed with water, immersed at 25° C for one minute in a 10% sulfuric acid solution to neutralize, and then washed with water. The resulting aluminum plate was electrolytically etched using an alternating current at 25° C for 20 seconds at a current density of 50 A/dm² and at a frequency of 50 Hz in an aqueous 11 g/liter hydrochloric acid solution, washed with water, desmutted at 50° C for 10 seconds in a 1% sodium hydroxide solution, washed with water, neutralized at 50° C for 30 seconds in a 30 % sulfuric acid solution, and washed with water. The desmutted aluminum plate was anodized at 25° C for 40 seconds at a current density of 5 A/dm² and at a voltage of 15 V in a 20% sulfuric acid solution, and washed with water.

The resulting anodized aluminum plate was immersed in a 0.44% polyvinyl phosphonic acid aqueous solution at 75° C for 30 seconds, washed with pure water, and dried blowing cool air. Thus, support for a photopolymerizable light sensitive planographic printing plate material sample was obtained. The center line average surface roughness (Ra) of the support was 0.65 *µ*m.

### (Preparation of planographic printing plate material sample)

The following polymerizable light sensitive layer coating solution was coated on the resulting support using a wire bar, and dried at 90° C for 1.5 minutes to give a light sensitive layer with a dry thickness of 1.9 g/m². After that, the following protective layer coating solution was coated on the light sensitive layer using an applicator, and dried at 75° C for 1.5 minutes to give a protective layer with a dry thickness of 1.5 g/m² and to obtain a planographic printing plate material sample with the protective layer provided on the light sensitive layer. Thus, inventive planographic printing plate material samples 1 through 7 and comparative planographic printing plate material samples 1 through 4 were obtained.

| <<Polymerizable light sensitive layer coating solution>> | |
|---|---|
| Polymeric binder (As shown in Table 2) | 65.0 parts |
| Cyanine dye-1 | 4.0 parts |
| Iron-arene compound IRGACURE 261 (produced by Ciba Specialty Chemicals Co.) | 3.2 parts |
| Triazine Compound TAZ-107 (produced by Midori Kagaku Co., Ltd.) | 2.5 parts |
| Addition polymerizable ethylenically unsaturated monomer (Compound A) | 15.0 parts |
| Polyethylene glycol #200 dimethacrylate (NK ESTER-4G, produced by Shinnakamura Kagaku Kogyol Co., Ltd.) | 10.0 parts |
| Phthalocyanine pigment (MHI 454 produced by Mikuni Sikisosha, 30% MEK dispersion) | 3.0 parts |
| Hindered amine stabilizer (LS 770 produced by Sankyo Life-Tech Co., Ltd.) | 0.5 parts |
| Fluorine-contained surfactant (F-178K produced by Dainippon ink Kagaku Kogyo Co., Ltd.) | 0.5 parts |
| Cyclohexanone (bp. 155°C) | 550 parts |
| Isopropyl alcohol | 350 parts |
| <<Protective layer coating solution>> | |
| Polyvinyl alcohol AL06 (produced by Nippon Gosei Kagaku Co., Ltd.) | 99.5 parts |
| Surfactant Surfinol 465 (produced by Nisshin Kagaku Co., Ltd.) | 0.5 parts |
| Water | 900parts |

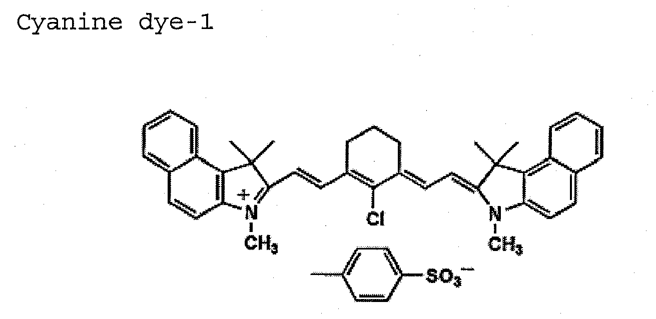

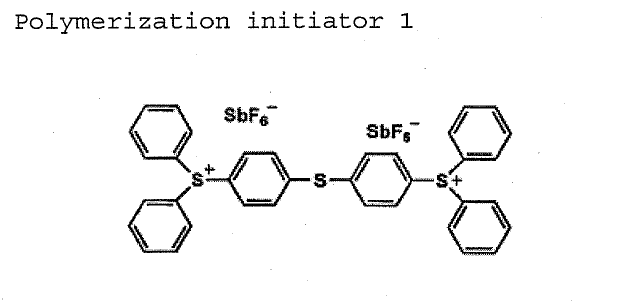

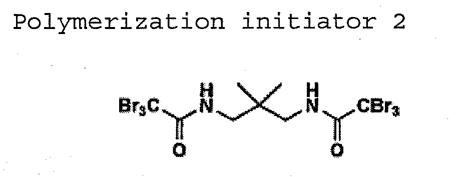

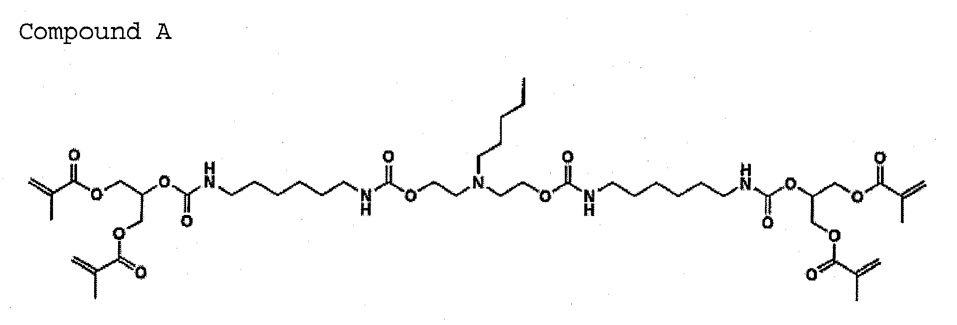

### (Evaluation of planographic printing plate material sample)

The planographic printing plate material sample obtained above was evaluated as follows.

### (Image formation)

### (Image formation employing infrared laser)

The resulting planographic printing plate material sample was imagewise exposed employing an infrared laser, a 808 nm laser with a beam spot diameter of about 18 µm. The planographic printing plate material sample was imagewise exposed at exposure energy of from 100 to 500 mJ/cm² to form an image with a resolving power of 2,400 dpi (dpi means a dot number per 2.54 cm) and a screen number of 175 line, the exposure energy being changed at an interval of 50 mJ/cm². The resulting sample was developed with a tap water while rubbing with a sponge for PS plates to obtain a planographic printing plate sample with a developed image. «Sensitivity, image formation property»

Each of the planographic printing plate material samples was imagewise exposed as above to the infrared laser above to form a 100% solid image, and then developed as described above to form a developed 100% solid image. Density of the developed solid image at each exposure energy level was measured through a densitometer D196 (produced by GRETAG Co., Ltd.). Exposure energy providing 90% of the maximum density of the developed solid image was defined as sensitivity.

### <<Storage stability>>

Each planographic printing plate material sample was stored at 55 °C and at 20% RH for 3 days in a thermostatic chamber. Sensitivity of the samples after and before storage was measured in the same manner as above, and sensitivity of the sample after storage was compared with that of the sample before storage. Sensitivity difference between the samples before and after storage was evaluated as one measure of storage stability.

The planographic printing plate material sample after the storage was exposed at an exposure energy providing sensitivity obtained above, and developed with water. The following anti-stain property was determined and evaluated as another measure of storage stability.

### <<Anti-stain property>>

The resulting planographic printing plate material sample was ink-processed employing a developing ink PI-2 and PS sponge, each produced by Fuji Photo Film Co., Ltd., sufficiently washed with water, followed by drying. The resulting planographic printing plate was observed with a loupe, and the anti-stain property was evaluated according to the following criteria:
A: No stain was observed.
B: Slight stain was observed.
C: Apparent stain was observed.

Further, the following evaluations were made.

### <<Uniformity of coated light sensitive layer>>

A light sensitive layer coating solution was prepared in a glass vessel, sufficiently stirred, and provided on a glass plate employing a syringe to form a coating. The insoluble matter in the coating was observed.

### <<Coatability of light sensitive layer coating solution>>

The light sensitive layer coating solution was coated on the support to form a light sensitive layer, and coatability of the light sensitive layer was visually observed.

### <<Water developability>>

Each of the printing plate material samples obtained above was immersed in a 25 °C ion-exchange water for 39 seconds, and lightly rubbed with a sponge and water developability (elimination property of the light sensitive layer of the sample) was evaluated.

### <<Image quality>>

Each of the printing plate material samples was imagewise exposed at exposure energy 50 mj/cm² higher than exposure energy providing sensitivity defined above, and developed in the same manner as above to form dot images with a screen line number of 150 lpi (lines per inch), the dot images having 1 to 99% dot areas at an interval of 1%. The resulting dot images were observed with a magnifying glass, and a dot area % range providing a uniform dot image was determined.

### <<On-press developability>>

Each of the printing plate material samples was exposed to the infrared laser while the exposure energy was changed. The exposed sample was mounted, without any development treatment, on a plate cylinder of a printing press, DAIYA 1F-1 produced by Mitsubishi Jukogyo Co., Ltd., and printing was carried out employing a coated paper, dampening water (SG-51, H solution produced by Tokyo Ink Co., Ltd., Concentration: 1.5%), and printing ink (Toyo King Hyecho M Magenta, produced by Toyo Ink Manufacturing Co.). When 100 printed sheets were obtained, then the sample surface was observed and the lowest exposure energy providing good on-press developability was determined as a measure of on-press developability. The less the lowest exposure energy is, the better the on-press developability.

### <<Number of paper wastes>>

Printing was carried out as above, except that a sample exposed at the lowest exposure energy was used, and the number of printing paper sheets printed from when printing started to when a print with good image quality (the number of paper wastes) was obtained was counted.

### <<Printing durability>>

Printing was carried out as above, except that a sample exposed at the lowest exposure energy was used, and the number of printing paper sheets printed from when a print with good image quality was obtained after on-press development was completed to when 3% variation of a dot image with a screen number of 175 lines was visually observed was counted as a measure of printing durability.

The results are shown in Table 2.

**Table 2**

| Sample No. | Polymeric binder | i) | ii) | iii) | iv) | v) | vi) | vii) | viii) | ix) |
|---|---|---|---|---|---|---|---|---|---|---|
| 1 (Inv.) | Polymer 1 | Good | Good | Good | 200 | 3-95% | A | 200 | 25 | 5000 |
| 2 (Inv.) | Polymer 2 | Good | Good | Good | 200 | 3-95% | A | 180 | 20 | 7500 |
| 3 (Inv.) | Polymer 3 | Good | Good | Good | 200 | 3-95% | A | 180 | 100 | 7000 |
| 4 (Inv.) | Polymer 4 | Good | Good | Good | 300 | 3-95% | A | 320 | 80 | 4000 |
| 5 (Inv.) | Polymer 5 | Good | Good | Good | 200 | 3-95% | A | 1800 | 20 | 6000 |
| 6 (Inv.) | Polymer 6 | Good | Good | Good | 150 | 3-95% | A | 150 | 20 | 7000 |
| 7 (Inv.) | Polymer 7 | Good | Good | Good | 200 | 3-95% | A | 200 | 25 | 5000 |
| 1 (Comp.) | x) | Good | Good | Poor | - | | C | | | |
| 2 (Comp.) | xi) | Good | Good | Good | 500 | 3-95% | A | 500 | 300 | 500 |
| 3 (Comp.) | xii) | Good | Good | Good | 500 | 20-80% | A | 500 | 300 | 500 |
| 4 (Comp.) | xiii) | Aggregates occurred | Coating defects | Poor | | | C | | | |

| | | | | | | | | | | |
|---|---|---|---|---|---|---|---|---|---|---|
| Inv.: Inventive, Comp.: Comparative | | | | | | | | | | |
| i) : Uniformity of coated light sensitive layer | | | | | | | | | | |
| ii) : Coatability | | | | | | | | | | |
| iii) : Water developability | | | | | | | | | | |
| iv) : Sensitivity (mj/cm²) | | | | | | | | | | |
| v) : Image quality 150 lpi | | | | | | | | | | |
| vi) : Anti-stain property | | | | | | | | | | |
| vii) : On-press developability (mj/cm²) | | | | | | | | | | |
| viii) : Paper wastes (number) | | | | | | | | | | |
| ix) : Printing durability (number) | | | | | | | | | | |
| x) : Comparative polymer 1 | | | | | | | | | | |
| xi) : Comparative polymer 2 | | | | | | | | | | |
| xii) : PVP K-30 (produced by Tokyo Kasei Co., Ltd.) | | | | | | | | | | |
| xiii) Polyvinyl alcohol PVA AL06 | | | | | | | | | | |

As is apparent from Table 2 above, inventive planographic printing plate material samples provide excellent developability, high sensitivity and excellent storage stability.

Further, planographic printing plate material samples were prepared in the same manner as above, except that the fluorine-contained surfactant was not used in the polymerizable light sensitive layer coating solution. The planographic printing plate material samples comprising no fluorine-contained surfactant provide poor ink receptivity, resulting in increase of paper wastes during printing.

### Example 2

Next, the following polymerizable light sensitive layer coating solution was prepared, and evaluation described later was made.

| <<Polymerizable light sensitive layer coating solution>> | |
|---|---|
| Polymeric binder (Polymer 1) | 65.0 parts |
| Cyanine dye-1 | 4.0 parts |
| Polymerization initiator (I) | amount shown in Table 3 |
| Polymerization initiator (II) | amount shown in Table 3 |
| Addition polymerizable ethylenically unsaturated monomer (Compound A) | 15.0 parts |
| Polyethylene glycol #200 dimethacrylate (NK ESTER-4G, produced by Shinnakamura Kagaku Kogyol Co., Ltd.) | 10.0 parts |
| Phthalocyanine pigment MHI 454 (produced by Mikuni Sikisosha, 30% MEK dispersion) | 3.0 parts |
| Hindered amine stabilizer (LS 770 produced by Mitusi Life-Tech Co., Ltd.) | 0.5 parts |
| Fluorine-contained surfactant (F-178K produced by Dainippon ink Kagaku Kogyo Co., Ltd.) | 0.5 parts |
| Cyclohexanone (bp. 155°C) | 550 parts |
| Isopropyl alcohol | 350 parts |

A planographic printing plate material sample was prepared in the same manner as in Example 1, except that the polymerizable light sensitive layer coating solution above was used. Thus, inventive planographic printing plate material samples 8 through 12 as shown in Table 3 were obtained.

The resulting sample was exposed in the same manner as in Example 1 above. Two of each of the planographic printing plate material samples 8 through 12 were exposed, and one was heated before development and the other was not. Herein, the heating was carried out at 110±5 °C for 15 seconds.

The heating temperature was measured employing a thermo label (produced by Nichiyu Giken Co., Ltd.) adhered on the rear surface of the support opposite the light sensitive layer.

The resulting samples (heated and unheated) were evaluated for on-press developability, paper wastes, and printing durability as described below.

### «On-press developability»

Each of the printing plate material samples obtained above was exposed to the infrared laser while the exposure energy was changed. The exposed sample was mounted, without any development treatment, on a plate cylinder of a printing press, DAIYA 1F-1 produced by Mitsubishi Jukogyo Co., Ltd., and printing was carried out employing a coated paper, dampening water (SG-51, H solution produced by Tokyo Ink Co., Ltd., Concentration: 1.5%), and printing ink (Toyo King Hyecho M Magenta, produced by Toyo Ink Manufacturing Co.). When 100 printed sheets were obtained, then the sample surface was observed and the lowest exposure energy providing good on-press developability was determined as a measure of on-press developability. The less the lowest exposure energy is, the better the on-press developability.

### <<Paper wastes>>

### <<Number of paper wastes>>

Printing was carried out as above, except that a sample exposed at the lowest exposure energy was used, and the number of printing paper sheets printed from when printing started to when a print with good image quality (i.e., the number of paper wastes) was obtained was counted.

### <<Printing durability >>

Printing was carried out as above, except that a sample exposed at the lowest exposure energy was used, and the number of printing paper sheets printed from when a print with good image quality was obtained after on-press development was completed to when 3% variation of a dot image with a screen number of 175 lines was visually observed was counted as a measure of printing durability.

The results are shown in Table 3.

**Table 3**

| Sample No. | Polymerization initiator (I) (Parts by weight) | Polymerization initiator (II) (Parts by weight) | Unheated | | | Heated before development | | |
|---|---|---|---|---|---|---|---|---|
| | | | a) | b) | c) | a) | b) | c) |
| 8 (Inv.) | IRGACURE 261 (3.2) | TAZ107 (2.5) | 200 | 25 | 5000 | 200 | 25 | 8000 |
| 9 (Inv.) | IRGACURE 261 (3.2) | Polymerization initiator 2 (2.5) | 180 | 25 | 10000 | 180 | 25 | 20000 |
| 10 (Inv.) | Tetra-n-butylammonium triphenyl-mono-t-butyl borate (3.2) | Polymerization initiator 2 (2.5) | 150 | 25 | 20000 | 150 | 25 | 35000 |
| 11 (Inv.) | *HABI (3.2) | Polymerization initiator 2 (2.5) | 150 | 25 | 20000 | 150 | 25 | 35000 |
| 12 (Inv.) | Polymerization initiator 1 (3.2) | Polymerization initiator 2 (2.5) | 250 | 25 | 10000 | 250 | 25 | 20000 |

| | | | | | | | | |
|---|---|---|---|---|---|---|---|---|
| Inv.: Inventive | | | | | | | | |
| *HABI: 2,2'-Bis(2-chlorophenyl)-4,5,4',5'-tetraphenylbisimidazole | | | | | | | | |
| a) On-press developability (mj/cm²) | | | | | | | | |
| b) Paper wastes (number) | | | | | | | | |
| c) Printing durability (number) | | | | | | | | |

As is apparent from Table 3 above, inventive planographic printing plate material samples provide excellent developability, high sensitivity, and high printing durability, and further increase printing durability due to heat treatment.

## Claims

1. A negative working light sensitive planographic printing plate material comprising a support and provided thereon, a light sensitive layer containing a spectral sensitizing agent, a polymerization initiator, a polymerizable compound, and a polymer as a polymeric binder,
wherein the polymer has in the molecule a monomer unit with a polymerizable group and at least one of a polyvinyl ether chain, a polyvinyl pyrrolidone chain and a polyvinyl caprolactam chain.

2. The negative working light sensitive planographic printing plate material of claim 1, wherein the polymerizable group is a radically polymerizable group.

3. The negative working light sensitive planographic printing plate material of claim 1 or 2,wherein the polymer has an acid value of from 0 to 100.

4. The negative working light sensitive planographic printing plate material according to any of claims 1 to 3, wherein the polymer has in the side chain a carboxyl group.

5. The negative working light sensitive planographic printing plate material according to any of claims 1 to 4, wherein the polymer has an acid value of from 5 to 70.

6. The negative working light sensitive planographic printing plate material according to any of claims 1 to 5, wherein the polymerization initiator is at least one selected from the group consisting of a sulfonium compound, a metal arene compound, a polyhalogen compound, a boron compound, and a bisimidazole compound.

7. The negative working light sensitive planographic printing plate material according to any of claims 1 to 6, wherein the spectral sensitizing agent is a cyanine dye.

8. The negative working light sensitive planographic printing plate material according to any of claims 1 to 7, wherein the content of the monomer unit with a polymerizable group in the polymer is 5 to 50 mol%.

9. The negative working light sensitive planographic printing plate material according to any of claims 1 to 8, wherein the polyvinyl ether chain has a repeating unit represented by formula (1), the polyvinyl pyrrolidone chain has a repeating unit represented by formula (2), and the polyvinyl caprolactam chain has a repeating unit represented by formula (3): 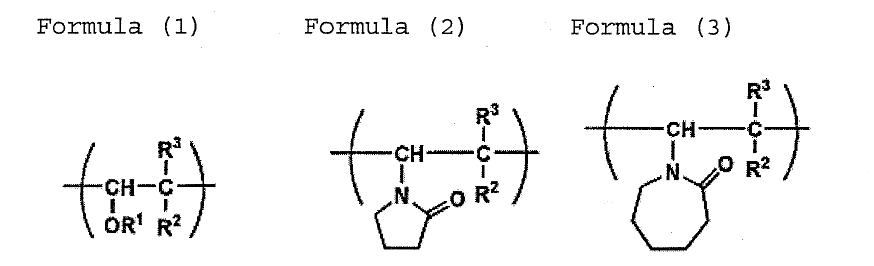 wherein R¹ represents a substituted or unsubstituted lower alkyl group, a substituted or unsubstituted cycloalkyl group, a substituted or unsubstituted aryl or heteroaryl group, or a substituted or unsubstituted aralkyl or heteroaralkyl group; R² and R³ independently represent a hydrogen atom, a substituted or unsubstituted lower alkyl group, a substituted or unsubstituted cycloalkyl group, a substituted or unsubstituted aryl or heteroaryl group, or a substituted or unsubstituted aralkyl or heteroaralkyl group.

10. The negative working light sensitive planographic printing plate material according to any of claims 1 to 9, wherein the polymer content of the light sensitive layer is from 10 to 90% by weight.

11. A process of manufacturing a planographic printing plate, the process comprising the steps of:
imagewise exposing to laser the negative working light sensitive planographic printing plate material of claim 1;
mounting the exposed planographic printing plate material on a plate cylinder of a press; and
developing the exposed planographic printing plate material with a dampening solution to obtain a planographic printing plate.

12. The manufacturing method of claim 11, wherein the laser is an infrared laser.

13. The manufacturing method of claim 11 or 12, wherein the planographic printing plate material is heat-treated before the developing step.

14. The manufacturing method of claim 11 , 12 or 13,
wherein the planographic printing plate material is heat-treated between the exposing step and the developing step.
